# EUROPÄISCHE PATENTANMELDUNG

(11) **EP 3 961 305 A2**
(43) Veröffentlichungstag der Anmeldung: **02.03.2022**
(21) Anmeldenummer: 21174906.4
(22) Anmeldetag: 20.05.2021
(51) Int. Cl.: G03F 7/20, G02B 7/00, G02B 7/182

(54) **KOMPENSATION VON KRIECHEFFEKTEN IN EINER ABBILDUNGSEINRICHTUNG**

(30) Priorität: 29.06.2020 DE 102020208009
(71) Anmelder: Carl Zeiss SMT GmbH, 73447 Oberkochen (DE)
(72) Erfinder: Nefzi, Marwene, 89073 Ulm (DE); Hembacher, Stefan, 86399 Bobingen (DE); Troeger, Stefan, 89073 Ulm (DE); Zweering, Ralf, 73431 Aalen (DE); Steimer, Konrad Carl, 68199 Mannheim (DE)
(74) Vertreter: Carl Zeiss SMT GmbH

(57) **Zusammenfassung**

Die vorliegende Erfindung betrifft eine Anordnung einer optischen Abbildungseinrichtung für die Mikrolithographie, insbesondere für die Verwendung von Licht im extremen UV-Bereich (EUV), mit einer ersten Stützstruktur (111.1) und einer zweiten Stützstruktur (111.2), wobei die erste Stützstruktur (111.1) dazu ausgebildet ist, wenigstens ein optisches Element (107.2) der Abbildungseinrichtung abzustützen. Die erste Stützstruktur (111.1) stützt die zweite Stützstruktur (111.2) über eine Mehrzahl von Stützfedereinrichtungen (113.1) einer Schwingungsentkopplungseinrichtung (113) ab, wobei die Stützfedereinrichtungen (113.1) kinematisch parallel zueinander zwischen der ersten Stützstruktur (111.1) und der zweiten Stützstruktur (111.2) wirken. Jede der Stützfedereinrichtungen (113.1) definiert eine Stützkraftrichtung sowie eine Stützlänge entlang der Stützkraftrichtung. Die zweite Stützstruktur (111.2) stützt eine Messeinrichtung (109.1) ab, die zum Messen der Position und/oder Orientierung des wenigstens einen optischen Elements bezüglich einer Referenz (112) in wenigstens einem Freiheitsgrad bis hin zu allen sechs Freiheitsgraden im Raum ausgebildet ist. Weiterhin ist eine Reduktionseinrichtung (115) zur Reduktion einer Änderung einer statischen Relativlage zwischen der ersten Stützstruktur (111.1) und der zweiten Stützstruktur (111.2) in wenigstens einem Korrekturfreiheitsgrad vorgesehen, wobei die Relativlageänderung insbesondere durch eine Längenänderung wenigstens einer der Stützfedereinrichtungen (113.1) entlang ihrer Stützkraftrichtung bedingt ist, die sich aus einem Kriechprozess der Stützfedereinrichtung (113.1) ergibt. Die Reduktionseinrichtung (115) umfasst eine kinematisch parallel zu den Stützfedereinrichtungen (113.1) zwischen der ersten Stützstruktur (111.1) und der zweiten Stützstruktur (111.2) wirkende Magneteinrichtung (115.1), die dazu ausgebildet ist, eine der Relativlageänderung entgegenwirkende Magnetstützkraft auszuüben.

## Beschreibung

Die vorliegende Erfindung betrifft eine optische Anordnung für die Mikrolithographie, die für die Verwendung von UV Nutzlicht geeignet ist, insbesondere von Licht im extremen ultravioletten (EUV) Bereich. Weiterhin betrifft die Erfindung eine optische Abbildungseinrichtung mit einer solchen Anordnung. Die Erfindung lässt sich im Zusammenhang mit beliebigen optischen Abbildungsverfahren einsetzen. Besonders vorteilhaft lässt sie sich bei der Herstellung oder der Inspektion mikroelektronischer Schaltkreise sowie der hierfür verwendeten optischen Komponenten (beispielsweise optischer Masken) einsetzen.

Die im Zusammenhang mit der Herstellung mikroelektronischer Schaltkreise verwendeten optischen Einrichtungen umfassen typischerweise eine Mehrzahl optischer Elementeinheiten, die ein oder mehrere optische Elemente wie Linsen, Spiegel oder optische Gitter umfassen, die im Abbildungslichtpfad angeordnet sind. Diese optischen Elemente wirken typischerweise in einem Abbildungsprozess zusammen, um ein Bild eines Objekts (beispielsweise ein auf einer Maske gebildetes Muster) auf ein Substrat (beispielsweise einen so genannten Wafer) zu transferieren. Die optischen Elemente sind typischerweise in einer oder mehreren funktionalen Gruppen zusammengefasst, die gegebenenfalls in separaten Abbildungseinheiten gehalten sind. Insbesondere bei hauptsächlich refraktiven Systemen, die mit einer Wellenlänge im so genannten Vakuum-Ultraviolett-Bereich (VUV, beispielsweise bei einer Wellenlänge von 193 nm) arbeiten, sind solche Abbildungseinheiten häufig aus einem Stapel optischer Module gebildet, die ein oder mehrere optische Elemente halten. Diese optischen Module umfassen typischerweise eine Stützstruktur mit einer im Wesentlichen ringförmigen äußeren Stützeinheit, die einen oder mehrere optische Elementhalter abstützt, die ihrerseits das optische Element halten.

Die immer weiter voranschreitende Miniaturisierung von Halbleiterbauelementen führt zu einem ständigen Bedarf an erhöhter Auflösung der zu ihrer Herstellung verwendeten optischen Systeme. Dieser Bedarf an erhöhter Auflösung bedingt den Bedarf an einer erhöhten numerischen Apertur (NA) und einer erhöhten Abbildungsgenauigkeit der optischen Systeme.

Ein Ansatz, um eine erhöhte optische Auflösung zu erhalten, besteht darin, die Wellenlänge des in dem Abbildungsprozess verwendeten Lichtes zu verringern. In den vergangenen Jahren wurde verstärkt die Entwicklung von Systemen vorangetrieben, bei denen Licht im so genannten extremen Ultraviolettbereich (EUV) verwendet wird, typischerweise bei Wellenlängen von 5 nm bis 20 nm, in den meisten Fällen bei einer Wellenlänge von etwa 13 nm. In diesem EUV-Bereich ist es nicht mehr möglich, herkömmliche refraktive optische Systeme zu verwenden. Dies ist dadurch bedingt, dass die für refraktive optische Systeme verwendeten Materialien in diesem EUV-Bereich einen Absorptionsgrad aufweisen, der zu hoch ist um mit der verfügbaren Lichtleistung akzeptable Abbildungsergebnisse zu erzielen. Folglich müssen in diesem EUV-Bereich reflektive optische Systeme für die Abbildung verwendet werden.

Dieser Übergang zu rein reflektiven optischen Systemen mit hoher numerischer Apertur (z. B. NA > 0,4 oder sogar NA > 0,5) im EUV-Bereich führt zu erheblichen Herausforderungen im Hinblick auf das Design der Abbildungseinrichtung.

Die oben genannten Faktoren führen zu sehr strengen Anforderungen hinsichtlich der Position und/oder Orientierung der optischen Elemente, die an der Abbildung teilnehmen, relativ zueinander sowie hinsichtlich der Deformation der einzelnen optischen Elemente, um eine gewünschte Abbildungsgenauigkeit erzielen. Zudem ist es erforderlich, diese hohe Abbildungsgenauigkeit über den gesamten Betrieb, letztlich über die Lebensdauer des Systems aufrechtzuerhalten.

Als Konsequenz müssen die Komponenten der optischen Abbildungseinrichtung (also beispielsweise die optischen Elemente der Beleuchtungseinrichtung, die Maske, die optischen Elemente der Projektionseinrichtung und das Substrat), die bei der Abbildung zusammenwirken, in einer wohldefinierten Weise abgestützt werden, um eine vorgegebene wohldefinierte räumliche Beziehung zwischen diesen Komponenten einzuhalten und eine minimale unerwünschte Deformation dieser Komponenten zu erzielen, um letztlich eine möglichst hohe Abbildungsqualität zu erreichen.

Eine Herausforderung besteht hierbei häufig darin, eine möglichst präzise Messung der Lage (also der Position und/oder Orientierung) der an der Abbildung beteiligten optischen Komponenten (beispielsweise der optischen Elemente) vorzunehmen und die Lage zumindest einzelner dieser optischen Elemente dann über eine entsprechend angesteuerte Lageregeleinrichtung aktiv mit der für den Abbildungsprozess erforderlichen Präzision (typischerweise im Bereich von 1 nm und darunter) und Regelbandbreite (typischerweise bis zu 200 Hz) einzustellen. Ein wesentlicher Faktor für die Präzision der Messung ist dabei die stabile und präzise Abstützung der Messeinrichtung, die für die Messung verwendet wird. Diese Abstützung sollte dabei nach Möglichkeit sicherstellen, dass die Komponenten der Messeinrichtung eine wohldefinierte Lage (d. h. Position und/oder Orientierung) bezüglich einer definierten Referenz aufweisen, auf die das Messergebnis der Messeinrichtung bezogen wird. Eine in diesem Zusammenhang häufig verwendete Möglichkeit, ist die Abstützung der Messeinrichtung auf einer separaten Stützstruktur, die häufig auch als Metrologie-Rahmen (englisch: "metrology frame") oder Sensor-Rahmen (englisch: "sensor frame") bezeichnet wird. Ein solcher Metrologie-Rahmen wird dabei typischerweise auf einer weiteren (ein- oder mehrteiligen) lasttragenden Struktur (englisch: "force frame") abgestützt, die neben dem Metrologie-Rahmen über die Lageregeleinrichtung auch zumindest einen Teil der optischen Komponenten (z. B. zumindest einen Teil der optischen Elemente) der Abbildungseinrichtung abstützt. Hierdurch kann sichergestellt werden, dass der Metrologie-Rahmen weit gehend von den Stützlasten für die optischen Komponenten frei gehalten werden kann.

Um den Metrologie-Rahmen hierbei möglichst weitgehend frei von inneren Störungen der Abbildungseinrichtung (z. B. durch bewegte Komponenten induzierte Vibrationen) und äußeren Störungen (z. B. unerwünschte Erschütterungen) zu halten, ist der Metrologie-Rahmen häufig über eine Schwingungsentkopplungseinrichtung schwingungsisoliert bzw. schwingungsentkoppelt auf der lasttragenden Struktur abgestützt. Dies geschieht typischerweise über eine Mehrzahl von Stützfedereinrichtungen der Schwingungsentkopplungseinrichtung.

Während hiermit (auf kurzen Zeitskalen) eine gute dynamische Schwingungsisolierung des Metrologie-Rahmens erreicht werden kann, hat es sich jedoch gezeigt, dass es auf langen Zeitskalen im Bereich der Schwingungsentkopplungseinrichtung, insbesondere im Bereich der Stützfedereinrichtungen, zu so genannten Kriecheffekten bzw. Setzeffekten kommen kann. Hierdurch ändert sich langfristig die Lage des Metrologie-Rahmens und damit die Lage der für die Ansteuerung der Lageregeleinrichtung verwendeten Referenz bezüglich der lasttragenden Struktur. Kriech- bzw. Setzeffekte (die im Folgenden vereinfachend auch nur unter dem Begriff "Kriecheffekte" zusammengefasst werden) können aber auch bei beliebigen anderen Stützkonzepten ohne derartige Schwingungsentkopplungseinrichtungen bzw. Stützfedereinrichtungen auftreten. Eine solche Lageänderung der Referenz wird im Betrieb typischerweise durch die Lageregeleinrichtung kompensiert, die hierzu allerdings ausreichende Verfahrwege, mithin also eine ausreichende Bewegungsreserve zur Verfügung stellen muss und demgemäß entsprechend aufwändig bzw. teuer gestaltet sein muss.

### KURZE ZUSAMMENFASSUNG DER ERFINDUNG

Der Erfindung liegt daher die Aufgabe zugrunde, eine optische Anordnung für die Mikrolithographie und eine entsprechende optische Abbildungseinrichtung mit einer solchen Anordnung sowie ein entsprechendes Verfahren zur Verfügung zu stellen, welche bzw. welches die zuvor genannten Nachteile nicht oder zumindest in geringerem Maße aufweist und insbesondere auf möglichst einfache und kostengünstige Weise eine optische Abbildung möglichst hoher Abbildungsqualität ermöglicht.

Die Erfindung löst diese Aufgabe mit den Merkmalen der unabhängigen Ansprüche.

Der Erfindung liegt die technische Lehre zugrunde, dass man auf einfache und kostengünstige Weise eine optische Abbildung hoher Abbildungsqualität erzielen kann, wenn kinematisch parallel zu den Stützfedereinrichtungen zwischen der lasttragenden ersten Stützstruktur und der die Messeinrichtung tragenden zweiten Stützstruktur eine Magneteinrichtung vorgesehen wird, die eine der Relativlageänderung entgegenwirkende Magnetstützkraft ausübt. Dabei kann man in einfacher Weise den Umstand nutzen, dass die Magnetstützkraft, die beispielsweise durch Abstoßung zweier Magneten erzeugt wird, mit zunehmender Annäherung der Magnete überproportional ansteigt.

Einer Relativlageänderung der beiden Stützstrukturen kann damit in einfacher und passiver Weise ein stark zunehmender Widerstand durch die Magnetstützkraft entgegengesetzt werden, der insgesamt das Ausmaß der Relativlageänderung erheblich reduziert. Ebenso kann durch die Magnetstützkraft aber auch eine erhebliche Entlastung der Stützfedereinrichtungen erzielt werden, wodurch Kriech- oder Setzeffekte im Bereich der Stützfedereinrichtungen gegebenenfalls erheblich reduziert werden können.

Der Begriff "statische Relativlageänderung" soll dabei im Sinne der vorliegenden Erfindung so verstanden werden, dass es sich um die Änderung der Relativlage bzw. eine Drift zwischen der ersten Stützstruktur und der zweiten Stützstruktur handelt, die im rein statischen Zustand, d. h. ohne dynamische Anregung der Strukturen vorliegt. Wie nachfolgend noch näher erläutert wird, kann eine solche statische Relativlageänderung bzw. Drift über geeignete Verfahren erfasst werden, welche kurzfristige bzw. dynamische Einflüsse herausfiltern. So kann beispielsweise eine einfache Mittelung der Relativlageinformation über geeignet lange Zeiträume erfolgen.

Bei herkömmlichen Gestaltungen kann es je nach Ausmaß der statischen Relativlageänderung zu einer vergleichsweise starken statischen (bzw. nicht-dynamischen) Auslenkung der Lageregeleinrichtung und damit der optischen Elemente aus ihrer ursprünglichen Ausgangslage kommen, mit der diese Relativlageänderung kompensiert wird, mithin also die optischen Elemente dieser Relativlageänderung folgen. Dies kann so weit führen, dass die Lageregeleinrichtung nicht mehr in der Lage ist, den für die dynamische Lageregelung der optischen Elemente im Betrieb erforderlichen Verfahrweg aufzubringen, da sie insoweit an ihre Grenzen stößt.

Dieser Konflikt kann bei herkömmlichen Gestaltungen nur gelöst werden, indem die Lageregeleinrichtung mit einem entsprechend großen Bewegungsspielraum ausgeführt wird, der es erlaubt, über die Lebensdauer der Abbildungseinrichtung entsprechend zu reagieren. Dies ist allerdings mit vergleichsweise hohen Kosten verbunden, da gerade eine Verfahrbewegung mit entsprechend hoher Dynamik nur mit vergleichsweise hohem Aufwand zu realisieren ist. Der Teil des dynamischen Bewegungsspielraumes der Lageregeleinrichtung, mit dem die optischen Elemente der statischen Relativlageänderung nachgeführt werden, ist damit letztlich unter Kostengesichtspunkten verschwendet.

Mit der vorliegenden magnetischen Kompensation ist es demgegenüber in einfacher und vorteilhafter Weise möglich, die Relativauslenkung der zweiten Stützstruktur und damit der Referenz auch während einer bestimmten längeren Betriebszeit, über die sich gegebenenfalls Kriech- oder Setzeffekte in der Abstützung der zweiten Stützstruktur spürbar ausgewirkt haben bzw. hätten, durch einfache, gegebenenfalls rein passive Mittel zumindest deutlich zu reduzieren. Wird die Magneteinrichtung zumindest intermittierend aktiv gestaltet (also beispielsweise so, dass ihre Stützkraft beispielsweise durch Erhöhung der Magnetisierung aktiv erhöht werden kann), kann die zweite Stützstruktur und damit die Referenz gegebenenfalls sogar wieder in ihren Ausgangszustand (oder in dessen Nähe) zurückgesetzt werden, den sie nach einer initialen Justage der Abbildungseinrichtung (typischerweise unmittelbar bei erstmaliger Inbetriebnahme der Abbildungseinrichtung) innehatte. Dies hat zur Folge, dass dann auch die der Referenz folgende Lageregeleinrichtung bzw. die von der Lageregeleinrichtung getragenen optischen Elemente wieder in ihren Ausgangszustand zurückgeholt werden. Eine Drift in der Lageregeleinrichtung wird somit im passiven Fall erheblich reduziert, im aktiven Fall sogar zumindest im Wesentlichen beseitigt.

Hiermit ist es insbesondere in einfacher und vorteilhafter Weise möglich, den maximal erforderlichen bzw. möglichen Verfahrweg der Lageregeleinrichtung vergleichsweise gering zu halten bzw. auf das Nötigste zu beschränken. Insbesondere ist keine große Bewegungsreserve für die Kompensation langfristiger Kriech- oder Setzeffekte vorzuhalten. Diese Bewegungsreserve kann deutlich kleiner gehalten werden.

Nach einem Aspekt betrifft die Erfindung daher eine Anordnung einer optischen Abbildungseinrichtung für die Mikrolithographie, insbesondere für die Verwendung von Licht im extremen UV-Bereich (EUV), mit einer ersten Stützstruktur und einer zweiten Stützstruktur, wobei die erste Stützstruktur dazu ausgebildet ist, wenigstens ein optisches Element der Abbildungseinrichtung abzustützen. Die erste Stützstruktur stützt die zweite Stützstruktur über eine Stützeinrichtung ab. Die zweite Stützstruktur stützt eine Messeinrichtung ab, die zum Messen der Position und/oder Orientierung des wenigstens einen optischen Elements bezüglich einer Referenz, insbesondere einer Referenz der zweiten Stützstruktur, in wenigstens einem Freiheitsgrad bis hin zu allen sechs Freiheitsgraden im Raum ausgebildet ist. Es ist eine Reduktionseinrichtung zur Reduktion einer Änderung einer statischen Relativlage zwischen der ersten Stützstruktur und der zweiten Stützstruktur in wenigstens einem Korrekturfreiheitsgrad vorgesehen. Die Reduktionseinrichtung umfasst eine kinematisch parallel zu der Stützreinrichtung zwischen der ersten Stützstruktur und der zweiten Stützstruktur wirkende Magneteinrichtung, die dazu ausgebildet ist, eine der Relativlageänderung entgegenwirkende Magnetstützkraft auszuüben.

Die Stützeinrichtung kann dabei grundsätzlich beliebig gestaltet sein, insbesondere kann es sich um eine aktive (d.h. aktiv verstellbare) oder passive Stützeinrichtung handeln. Dabei kann die erste Stützstruktur die zweite Stützstruktur beispielsweise über eine Mehrzahl von Stützeinheiten abstützen, die kinematisch parallel zueinander zwischen der ersten Stützstruktur und der zweiten Stützstruktur wirken. Bei vorteilhaften Varianten stützt die erste Stützstruktur die zweite Stützstruktur über eine Mehrzahl von Stützfedereinrichtungen einer Schwingungsentkopplungseinrichtung der Stützeinrichtung ab, wobei die Stützfedereinrichtungen kinematisch parallel zueinander zwischen der ersten Stützstruktur und der zweiten Stützstruktur wirken. Jede der Stützfedereinrichtungen definiert dabei eine Stützkraftrichtung, in der sie eine Stützkraft zwischen der ersten Stützstruktur und der zweiten Stützstruktur ausübt, sowie eine Stützlänge entlang der Stützkraftrichtung. Die Relativlageänderung kann dann durch eine Längenänderung wenigstens einer der Stützfedereinrichtungen entlang ihrer Stützkraftrichtung bedingt sein, die sich aus einem Kriechprozess der Stützfedereinrichtung ergibt. Die Magneteinrichtung wirkt dann kinematisch parallel zu den Stützfedereinrichtungen zwischen der ersten Stützstruktur und der zweiten Stützstruktur. Die Reduktionseinrichtung kann in diesem Fall dann auch als Kriechreduktionseinrichtung bezeichnet werden.

Die Magneteinrichtung kann grundsätzlich beliebig gestaltet sein und eine beliebig hohe, auf die Kraft der Stützfedereinrichtungen abgestimmte Magnetstützkraft ausüben. So ist es gegebenenfalls möglich, einen hohen Anteil der Gesamtgewichtskraft der zweiten Stützstruktur und der von der zweiten Stützstruktur getragenen Komponenten durch die Magnetstützkraft aufzunehmen, sodass die Stützfedereinrichtungen deutlich geringer belastet sind (gegebenenfalls also sogar nur die dynamischen Lasten aufnehmen müssen), wodurch Kriech- und Setzeffekte reduziert werden können. Bevorzugt ist die Magneteinrichtung derart ausgebildet, dass sie wenigstens einen Anteil der Gesamtgewichtskraft der zweiten Stützstruktur und der von der zweiten Stützstruktur getragenen Komponenten aufnimmt. Dieser Anteil kann beliebig hoch ausfallen. Vorzugsweise beträgt der Anteil wenigstens 0,5% bis 20%, vorzugsweise wenigstens 1% bis 15%, weiter vorzugsweise wenigstens 2% bis 5%, der Gesamtgewichtskraft. Hiermit lassen sich insbesondere unter dynamischen Gesichtspunkten besonders günstige Varianten erzielen.

Bei bevorzugten Varianten umfasst die Magneteinrichtung wenigstens ein Magneteinheitenpaar aus zwei einander zugeordneten Magneteinheiten, die zur Erzeugung der Magnetstützkraft zumindest in Richtung der Magnetstützkraft berührungslos zusammenwirken. Dabei kann eine erste Magneteinheit eines Magneteinheitenpaares mechanisch mit der ersten Stützstruktur verbunden sein und eine zweite Magneteinheit des Magneteinheitenpaares mechanisch mit der zweiten Stützstruktur verbunden sein. Weiterhin können bei bestimmten Varianten die Magneteinheiten wenigstens eines Magneteinheitenpaares derart ausgebildet und angeordnet sein, dass ihr Beitrag zu der Magnetstützkraft über eine gegenseitige Abstoßung der beiden Magneteinheiten erfolgt. Ebenso können bei bestimmten Varianten die Magneteinheiten wenigstens eines Magneteinheitenpaares derart ausgebildet und angeordnet sein, dass ihr Beitrag zu der Magnetstützkraft über eine gegenseitige Anziehung der beiden Magneteinheiten erfolgt. Hiermit lassen sich jeweils besonders einfache Gestaltungen realisieren. Dabei versteht es sich, dass die vorgenannten Varianten (mit Anziehung und Abstoßung) beliebig kombiniert werden können.

Die Magneteinrichtung bzw. ihr wenigstens eines Magneteinheitenpaar können der Stützeinrichtung (beispielsweise einer oder mehreren Stützeinheiten bzw. Stützfedereinrichtungen) grundsätzlich auf beliebige geeignete Weise funktionell, insbesondere räumlich, zugeordnet sein. Bevorzugt geschieht dies natürlich in Abstimmung auf ein zu erwartendes Kriech- bzw. Setzverhalten der Stützeinrichtung (beispielsweise einer oder mehrerer Stützeinheiten bzw. Stützfedereinrichtungen). Besonders vorteilhaft ist es, wenn der Stützeinrichtung (beispielsweise wenigstens einer oder mehreren Stützeinheiten bzw. Stützfedereinrichtungen) wenigstens ein Magneteinheitenpaar funktionell, insbesondere räumlich, zugeordnet ist. Eine besonders einfache Abstimmung mit einfacher bedarfsgerechter Kompensation von Kriech- bzw. Setzeffekten ist dann möglich, wenn mehreren der Stützeinheiten bzw. der Stützfedereinrichtungen, insbesondere jeder der Stützeinheiten bzw. der Stützfedereinrichtungen, jeweils wenigstens ein Magneteinheitenpaar, insbesondere genau ein Magneteinheitenpaar, funktionell zugeordnet ist.

Wie bereits erwähnt, können grundsätzlich aktive Magneteinheitenpaare verwendet werden, deren Magnetstützkraft zumindest intermittierend aktiv verändert bzw. eingestellt werden kann. Besonders einfache, insoweit passive Konfigurationen ergeben sich allerdings, wenn wenigstens eine Magneteinheit der Magneteinrichtung wenigstens einen Permanentmagneten umfasst. Dabei können in besonders einfachen Fällen die beiden Magneteinheiten eines Magneteinheitenpaares der Magneteinrichtung jeweils wenigstens einen Permanentmagneten umfassen. Solche Konfigurationen zeichnen sich dann durch eine besonders einfache Gestaltung und einen überproportionalen Verlauf der Magnetstützkraft in Abhängigkeit vom Abstand der beiden Magneteinheiten aus. Bei weiteren Varianten kann wenigstens eine erste Magneteinheit eines Magneteinheitenpaares der Magneteinrichtung eine Mehrzahl von Permanentmagneten umfassen, deren Magnetfelder einander derart überlagert sind, dass in Richtung des Beitrags zur Magnetstützkraft, der durch das Magneteinheitenpaar erzeugt wird, über einen vorgebbaren Bewegungsabschnitt eine Magnetstützkraft mit einem vorgebbaren Verlauf auf eine zweite Magneteinheit eines Magneteinheitenpaares wirkt.

Dabei kann insbesondere über einen vorgebbaren Bewegungsabschnitt eine im Wesentlichen konstante Magnetkraft realisiert sein. Das Magneteinheitenpaar weist in diesem Fall dann eine Steifigkeit zumindest nahe Null auf, was unter dynamischen Gesichtspunkten besonders vorteilhaft sein kann, da das dynamische Schwingungsentkopplungsverhalten dann insoweit primär bzw. sogar ausschließlich beispielsweise über die Stützfedereinrichtungen definiert wird.

Bei bestimmten Varianten kann vorgesehen sein, dass die Magneteinrichtung derart ausgebildet ist, dass die Magnetstützkraft mit zunehmender Relativlageänderung zumindest abschnittsweise proportional zunimmt. Insbesondere kann die Magneteinrichtung derart ausgebildet sein, dass die Magnetstützkraft mit zunehmender Relativlageänderung zumindest abschnittsweise überproportional zunimmt. Beide Varianten sind natürlich auf die Stützfedereinrichtungen abgestimmt und führen in vorteilhafter Weise zu der oben bereits beschriebenen Reduktion der statischen Relativauslenkung.

Die wenigstens eine Magneteinheit der Magneteinrichtung kann grundsätzlich so gestaltet sein, dass sie bereits selbst die erforderliche Entkopplung in den (für die Abstützung der zweiten Stützstruktur) erforderlichen Entkopplungsfreiheitsgraden zur Verfügung stellt. Bei weiteren Varianten übt die wenigstens eine Magneteinheit der Magneteinrichtung im Betrieb in einer Stützkraftrichtung eine magnetisch erzeugte Stützkraft auf eine der Stützstrukturen aus, wobei die wenigstens eine Magneteinheit über eine Entkopplungseinrichtung mechanisch mit der Stützstruktur verbunden ist, insbesondere mit der zweiten Stützstruktur verbunden ist. Die Entkopplungseinrichtung ist dann dazu ausgebildet, in wenigstens einem von der Stützkraftrichtung verschiedenen Entkopplungsfreiheitsgrad eine zumindest teilweise mechanische Entkopplung zwischen der Magneteinheit und der Stützstruktur zu erzeugen. Dabei kann der wenigstens eine Entkopplungsfreiheitsgrad ein translatorischer Freiheitsgrad sein, der quer zu der Stellkraftrichtung verläuft. Zusätzlich oder alternativ kann der wenigstens eine Entkopplungsfreiheitsgrad ein rotatorischer Freiheitsgrad um eine Achse sein, die quer zu der Stellkraftrichtung verläuft. In allen diesen Fällen kann auf einfache Weise eine günstige Schwingungsentkopplung erzielt werden.

Bei bestimmten besonders einfach zu realisierenden Varianten übt die wenigstens eine Magneteinheit der Magneteinrichtung im Betrieb in einer Stützkraftrichtung eine magnetisch erzeugte Stützkraft auf eine der Stützstrukturen aus, wobei die wenigstens eine Magneteinheit über eine Entkopplungseinrichtung, die sich in der Stützkraftrichtung erstreckt, mechanisch mit der Stützstruktur verbunden ist. Dabei kann die Entkopplungseinrichtung ein in der Stützkraftrichtung langgestrecktes biegeweiches Entkopplungselement umfassen, um in einfacher Weise die Entkopplung zu erzielen. Zusätzlich oder alternativ kann die Entkopplungseinrichtung ein in der Stützkraftrichtung langgestrecktes Blattfederelement umfassen, um in einfacher Weise die Entkopplung zu erzielen. Zusätzlich oder alternativ kann die Entkopplungseinrichtung ein in der Stützkraftrichtung langgestrecktes und schlankes, insbesondere biegeweiches, Stabfederelement umfassen, um in einfacher Weise die Entkopplung zu erzielen.

Bei bevorzugten Varianten ist eine Steuereinrichtung vorgesehen, die dazu ausgebildet ist, in Abhängigkeit von einer Zustandsänderung der Stützeinrichtung, insbesondere in Abhängigkeit von einer Längenänderung wenigstens einer Stützfedereinrichtung der Stützeinrichtung entlang ihrer Stützkraftrichtung, die Magneteinrichtung zur Änderung der Magnetstützkraft anzusteuern. Dabei kann die Steuereinrichtung zur Ermittlung der Zustandsänderung ein das Lageänderungsverhalten der Stützeinrichtung beschreibendes, insbesondere zeitabhängiges, Zustandsänderungsmodell verwenden. Beispielsweise kann die Steuereinrichtung zur Ermittlung der Längenänderung der wenigstens einen Stützfedereinrichtung entlang ihrer Stützkraftrichtung ein das Kriechverhalten der Stützfedereinrichtung beschreibendes, insbesondere zeitabhängiges, Kriechmodell der Stützfedereinrichtung verwenden.

Bei bestimmten Varianten sind eine Erfassungseinrichtung und eine Steuereinrichtung vorgesehen, wobei die Erfassungseinrichtung dazu ausgebildet ist, wenigstens einen für die Relativlage zwischen der ersten Stützstruktur und der zweiten Stützstruktur in wenigstens einem Korrekturfreiheitsgrad repräsentativen Relativlageerfassungswert zu erfassen und an die Steuereinrichtung auszugeben. Die Steuereinrichtung ist dazu ausgebildet, in einem Kompensationsmodus in Abhängigkeit von dem Relativlageerfassungswert, insbesondere in Abhängigkeit von einer zeitlichen Änderung des Relativlageerfassungswerts, die Magneteinrichtung zur Änderung der Magnetstützkraft anzusteuern.

Das Ändern der Magnetstützkraft in dem Kompensationsmodus kann grundsätzlich zu beliebigen geeigneten Zeitpunkten bzw. ausgelöst durch beliebige zeitliche Ereignisse (beispielsweise vorgebbare Intervalle) und/oder nicht-zeitliche Ereignisse (beispielsweise erfasste Schocklasten, Erreichen einer bestimmten Anzahl von Abbildungsvorgängen, das Starten oder Herunterfahren der Abbildungseinrichtung etc.) erfolgen.

Bei bestimmten Varianten ist die Steuereinrichtung dazu ausgebildet, den Kompensationsmodus zu aktivieren, wenn eine die durch eine Relativlageänderungsinformation bzw. einen Relativlageerfassungswert repräsentierte Relativlageänderung einen vorgebbaren Grenzwert überschreitet. Hiermit kann natürlich besonders effizient und bedarfsgerecht auf die Kriech- bzw. Setzeffekte reagiert werden.

Zusätzlich oder alternativ kann die Steuereinrichtung dazu ausgebildet sein, den Kompensationsmodus in Abhängigkeit von vorgebbaren Ereignissen, insbesondere in vorgebbaren zeitlichen Intervallen, zu aktivieren, wobei der Kompensationsmodus insbesondere 0,25 bis 10 Jahre, vorzugsweise 0,5 bis 5 Jahre, weiter vorzugsweise 1 bis 2 Jahre, nach einem Betriebsbeginn der Abbildungseinrichtung und/oder einer vorhergehenden Antivierung des Kriechkompensationsmodus aktiviert wird.

Die Steuereinrichtung kann grundsätzlich auf beliebige geeignete Weise gestaltet sein, eine dem jeweiligen optischen Abbildungsprozess angepasste Ansteuerung der Magneteinrichtung zu realisieren. Dabei können insbesondere beliebige geeignete Regelbandbreiten für die Ansteuerung der Stelleinrichtung vorgesehen sein. Bei besonders vorteilhaften Varianten weist die Steuereinrichtung eine Regelbandbreite von 10 Hz bis 1000 Hz, vorzugsweise 20 Hz bis 500 Hz, weiter vorzugsweise 50 Hz bis 300 Hz, auf.

Bei dem Freiheitsgrad bzw. den Freiheitsgraden, in denen eine für den Abbildungsprozess bzw. dessen Abbildungsfehler relevante Relativlageänderung durch Kriech- bzw. Setzeffekte erfolgt und denen durch die (passive oder aktive) Magneteinrichtung entgegengewirkt wird, kann es sich um beliebige Freiheitsgrade bis hin zu allen sechs Freiheitsgraden im Raum handeln. Dabei können im Fall einer aktiven Lösung beliebige geeignete Grenzwerte vorgegeben sein, bei deren Überschreitung die Änderung der Magnetstützkraft erforderlich bzw. vorgenommen wird.

Bei bestimmten Varianten ist der wenigstens eine Freiheitsgrad der Relativlageänderung ein Rotationsfreiheitsgrad, insbesondere ein Rotationsfreiheitsgrad um eine quer zu der Gravitationsrichtung verlaufende Kippachse. Der vorgebbare Grenzwert ist dann bevorzugt für eine Abweichung der Relativlage zwischen der ersten Stützstruktur und der zweiten Stützstruktur von einer vorgebbaren Relativsolllage um 1 µrad bis 500 µrad, vorzugsweise 10 µrad bis 300 µrad, weiter vorzugsweise 20 µrad bis 100 µrad, repräsentativ. Zusätzlich oder alternativ kann der wenigstens eine Freiheitsgrad der Relativlageänderung ein Translationsfreiheitsgrad sein, insbesondere ein Translationsfreiheitsgrad entlang der Gravitationsrichtung. Der vorgebbare Grenzwert ist dann bevorzugt für eine Abweichung der Relativlage zwischen der ersten Stützstruktur und der zweiten Stützstruktur von einer vorgebbaren Relativsolllage um 1 µm bis 500 µm, vorzugsweise 10 µm bis 300 µm, weiter vorzugsweise 20 µm bis 100 µm, repräsentativ.

Die vorliegenden Erfindung betrifft weiterhin eine optische Abbildungseinrichtung, insbesondere für die Mikrolithographie, mit einer Beleuchtungseinrichtung (102) mit einer ersten optischen Elementgruppe, einer Objekteinrichtung zur Aufnahme eines Objekts, einer Projektionseinrichtung mit einer zweiten optischen Elementgruppe und einer Bildeinrichtung, wobei die Beleuchtungseinrichtung zur Beleuchtung des Objekts ausgebildet ist und die Projektionseinrichtung zur Projektion einer Abbildung des Objekts auf die Bildeinrichtung ausgebildet ist. Die Beleuchtungseinrichtung und/oder die Projektionseinrichtung umfasst wenigstens eine erfindungsgemäße Anordnung. Hiermit lassen sich die oben beschriebenen Varianten und Vorteile in demselben Maße realisieren, sodass insoweit auf die obigen Ausführungen Bezug genommen wird.

Die vorliegenden Erfindung betrifft weiterhin ein Verfahren für eine optische Abbildungseinrichtung für die Mikrolithographie, insbesondere für die Verwendung von Licht im extremen UV-Bereich (EUV), bei dem eine erste Stützstruktur eine zweite Stützstruktur über eine Stützeinrichtung abstützt und dazu ausgebildet ist, wenigstens ein optisches Element der Abbildungseinrichtung abzustützen. Die zweite Stützstruktur stützt eine Messeinrichtung ab, die zum Messen der Position und/oder Orientierung des wenigstens einen optischen Elements bezüglich einer Referenz, insbesondere einer Referenz der zweiten Stützstruktur, in wenigstens einem Freiheitsgrad bis hin zu allen sechs Freiheitsgraden im Raum ausgebildet ist. Eine Änderung einer statischen Relativlage zwischen der ersten Stützstruktur und der zweiten Stützstruktur in wenigstens einem Freiheitsgrad in einem Kompensationsschritt wird zumindest reduziert, indem kinematisch parallel zu der Stützeinrichtung zwischen der ersten Stützstruktur und der zweiten Stützstruktur eine der Relativlageänderung entgegenwirkende magnetisch erzeugte Magnetstützkraft ausgeübt wird. Hiermit lassen sich die oben beschriebenen Varianten und Vorteile ebenfalls in demselben Maße realisieren, sodass insoweit auf die obigen Ausführungen Bezug genommen wird.

Weitere Aspekte und Ausführungsbeispiele der Erfindung ergeben sich aus den abhängigen Ansprüchen und der nachfolgenden Beschreibung bevorzugter Ausführungsbeispiele, die sich auf die beigefügten Figuren bezieht. Alle Kombinationen der offenbarten Merkmale, unabhängig davon, ob diese Gegenstand eines Anspruchs sind oder nicht, liegen im Schutzbereich der Erfindung.

### KURZE BESCHREIBUNG DER ZEICHNUNGEN

- Figur 1: ist eine schematische Darstellung einer bevorzugten Ausführung einer erfindungsgemäßen optischen Abbildungseinrichtung, die eine bevorzugte Ausführung einer erfindungsgemäßen optischen Anordnung umfasst.
- Figur 2: ist eine schematische Ansicht eines Teils der Abbildungseinrichtung aus Figur 1 in einem ersten Zustand.
- Figur 3: ist eine schematische Ansicht des Teils der Abbildungseinrichtung aus Figur 2 in einem zweiten Zustand.
- Figur 4: ist eine schematische Ansicht des Teils einer Variante der Abbildungseinrichtung aus Figur 2.
- Figur 5: ist eine schematische Ansicht des Teils einer weiteren Variante der Abbildungseinrichtung aus Figur 2.
- Figur 6: ist eine schematische Ansicht des Teils einer weiteren Variante der Abbildungseinrichtung aus Figur 2.
- Figur 7: ist eine schematische Ansicht des Teils einer weiteren Variante der Abbildungseinrichtung aus Figur 2.
- Figur 8: ist ein Ablaufdiagramm eines bevorzugten Ausführungsbeispiels eines erfindungsgemäßen Verfahrens, das mit der Abbildungseinrichtung aus Figur 1 durchgeführt werden kann.

### DETAILLIERTE BESCHREIBUNG DER ERFINDUNG

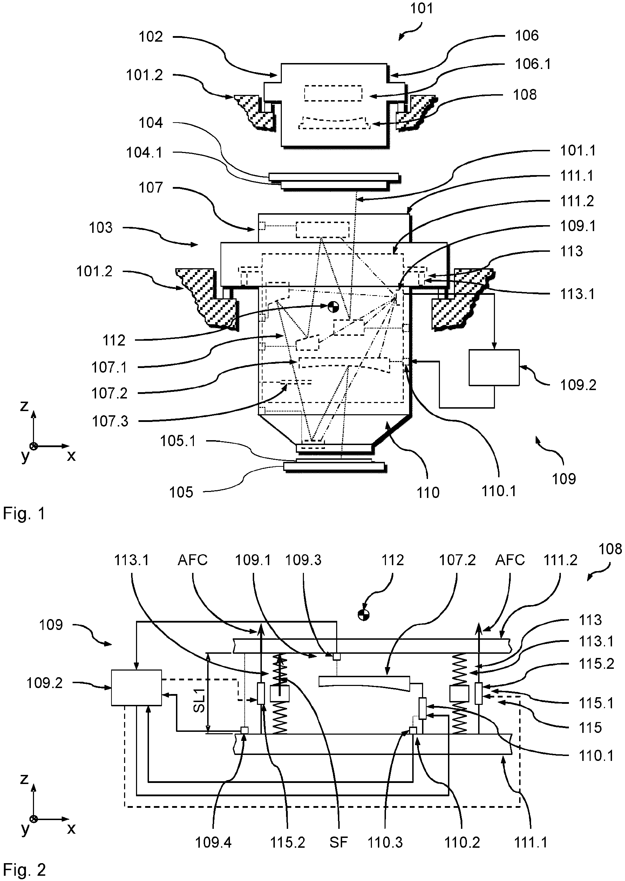

Im Folgenden werden unter Bezugnahme auf die Figuren 1 bis 8 bevorzugte Ausführungsbeispiele einer erfindungsgemäßen optischen Abbildungseinrichtung in Form einer Projektionsbelichtungsanlage 101 für die Mikrolithographie beschrieben, die bevorzugte Ausführungsbeispiele einer erfindungsgemäßen optischen Anordnung umfassen. Zur Vereinfachung der nachfolgenden Ausführungen wird in den Zeichnungen ein x,y,z-Koordinatensystem angegeben, wobei die z-Richtung der Richtung der Gravitationskraft entspricht. Selbstverständlich ist es in weiteren Ausgestaltungen möglich, beliebige davon abweichende Orientierungen eines x,y,z-Koordinatensystems zu wählen.

Figur 1 ist eine schematische, nicht maßstabsgetreue Darstellung der Projektionsbelichtungsanlage 101, die in einem Mikrolithographieprozess zur Herstellung von Halbleiterbauelementen verwendet wird. Die Projektionsbelichtungsanlage 101 umfasst eine Beleuchtungseinrichtung 102 und eine Projektionseinrichtung 103. Die Projektionseinrichtung 103 ist dazu ausgebildet, in einem Belichtungsprozess ein Bild einer Struktur einer Maske 104.1, die in einer Maskeneinheit 104 angeordnet ist, auf ein Substrat 105.1 zu übertragen, das in einer Substrateinheit 105 angeordnet ist. Dazu beleuchtet die Beleuchtungseinrichtung 102 die Maske 104.1. Die optische Projektionseinrichtung 103 empfängt das Licht von der Maske 104.1 und projiziert das Bild der Maskenstruktur der Maske 104.1 auf das Substrat 105.1, wie z.B. einen Wafer oder dergleichen.

Die Beleuchtungseinrichtung 102 umfasst eine optische Einheit 106 mit einer optischen Elementgruppe 106.1. Die Projektionseinrichtung 103 umfasst eine weitere optische Einheit 107 mit einer optischen Elementgruppe 107.1. Die optischen Elementgruppen 106.1, 107.1 sind entlang eines gefalteten Mittenstrahlverlaufs 101.1 der Projektionsbelichtungsanlage 101 angeordnet. Jede der optischen Elementgruppen 106.1, 107.1 kann eine beliebige Vielzahl optischer Elemente umfassen.

In dem vorliegenden Ausführungsbeispiel arbeitet die Projektionsbelichtungsanlage 101 mit Nutzlicht im EUV-Bereich (extrem ultraviolette Strahlung), mit Wellenlängen zwischen 5 nm bis 20 nm, insbesondere mit einer Wellenlänge von 13 nm. Bei den optischen Elementen der Elementgruppen 106.1, 107.1 der Beleuchtungseinrichtung 102 und der Projektionseinrichtung 103 handelt es sich daher ausschließlich um reflektive optische Elemente. Die optischen Elementgruppen 106.1, 107.1 können ein oder mehrere erfindungsgemäße optischen Anordnungen umfassen, wie dies nachfolgend anhand der optischen Anordnung 108 beschrieben wird. Die optischen Einheiten 106 und 107 sind jeweils über eine Basisstruktur 101.2 abgestützt.

In weiteren Ausgestaltungen der Erfindung ist es (insbesondere in Abhängigkeit von der Wellenlänge des Beleuchtungslichts) selbstverständlich auch möglich, für die optischen Module jede Art von optischen Elementen (refraktiv, reflektiv, diffraktiv) alleine oder in beliebiger Kombination einzusetzen.

Die erfindungsgemäße Anordnung wird im Folgenden beispielhaft anhand der Anordnung 108 beschrieben, die ein Teil der Projektionseinrichtung 103 ist. Bei der Abbildungseinrichtung 101 bestehen unter anderem sehr strenge Anforderungen hinsichtlich der Position und/oder Orientierung der optischen Elemente der optischen Elementgruppe 107.1 der Projektionseinrichtung 103 relativ zueinander, um eine gewünschte Abbildungsgenauigkeit erzielen. Zudem ist es erforderlich, diese hohe Abbildungsgenauigkeit über den gesamten Betrieb, letztlich über die Lebensdauer des Systems aufrechtzuerhalten.

Als Konsequenz müssen die optischen Elemente der optischen Elementgruppe 107.1 in einer wohldefinierten Weise abgestützt werden, um eine vorgegebene wohldefinierte räumliche Beziehung zwischen den optischen Elementen der Elementgruppe 107.1 und den übrigen optischen Komponenten einzuhalten und so letztlich eine möglichst hohe Abbildungsqualität zu erreichen.

Hierzu wird im vorliegenden Beispiel eine Messung der Lage (also der Position und/oder Orientierung) der optischen Elemente der Elementgruppe 107.1 mittels einer (in Figur 1 nur sehr vereinfacht dargestellten) Messeinrichtung 109.1 einer Steuereinrichtung 109 vorgenommen. Die Messeinrichtung 109.1 liefert ihre Messsignale LMS an eine Steuereinheit 109.2 der Steuereinrichtung 109. Die Steuereinheit 109.2 steuert dann in Abhängigkeit von den Messsignalen LMS der Messeinrichtung 109.1 eine Lageregeleinrichtung 110 an, die auf einer lasttragenden ersten Struktur 111.1 abgestützt ist. Über die Lageregeleinrichtung 110 wird dann die Lage jedes der optischen Elemente der Elementgruppe 107.1 bezüglich einer zentralen Referenz 112 aktiv mit der für den Abbildungsprozess erforderlichen Präzision (typischerweise im Bereich von 1 nm und darunter) und Regelbandbreite (typischerweise bis zu 200 Hz) eingestellt.

Im vorliegenden Beispiel gibt die Messeinrichtung 109.1 eine Messinformation MI an die Lageregeleinrichtung 110 aus, die für die jeweiligen Position und/oder Orientierung des jeweiligen optischen Elements der Elementgruppe 107.1 bezüglich der Referenz 112 in wenigstens einem Freiheitsgrad im Raum repräsentativ ist. Im Zustand bei der erstmaligen Inbetriebnahme der Abbildungseinrichtung 101 (in dem sich die Abbildungseinrichtung 101 in einem ersten Betriebszustand OM1 befindet) steuert die Steuereinheit 109.2 somit die Lageregeleinrichtung 110 in Abhängigkeit von der Messinformation MI entsprechend an, um einen ersten Sollzustand S1 der Position und/oder Orientierung der optische Elemente der Elementgruppe 107.1 bezüglich der Referenz 112 zu erzeugen, wie es in Figur 2 für ein optisches Element 107.2 der Elementgruppe 107.1 dargestellt ist.

Ein wesentlicher Faktor für die erzielbare Abbildungsqualität der Abbildungseinrichtung 101 ist die Präzision der Messung der Messeinrichtung 109.1, die wiederum von einer möglichst stabilen und präzisen Abstützung der Messeinrichtung 109.1 abhängt. Diese Abstützung sollte dabei nach Möglichkeit sicherstellen, dass die Komponenten der Messeinrichtung 109.1 eine wohldefinierte Lage (d. h. Position und/oder Orientierung) bezüglich der zentralen Referenz 112 aufweisen, auf die das Messergebnis der Messeinrichtung 109.1 bezogen wird.

Hierzu sind die Messeinheiten 109.3 der Messeinrichtung 109.1 auf einer separaten zweiten Stützstruktur 111.2 abgestützt, die häufig auch als Metrologie-Rahmen bezeichnet wird. Der Metrologie-Rahmen 111.2 ist seinerseits der (ein- oder mehrteiligen) lasttragenden ersten Struktur 111.1 abgestützt. Hierdurch kann sichergestellt werden, dass der Metrologie-Rahmen 111.2 weit gehend von den Stützlasten für die optischen Elemente der Elementgruppe 107.1 frei gehalten werden kann.

Um den Metrologie-Rahmen 111.2 möglichst weitgehend frei von inneren Störungen der Abbildungseinrichtung 101 (z. B. durch bewegte Komponenten induzierte Vibrationen) und äußeren Störungen (z. B. unerwünschte Erschütterungen) zu halten, ist der Metrologie-Rahmen 111.2 über eine Stützeinrichtung 113 auf der lasttragenden Struktur 111.1 abgestützt. Die Stützeinrichtung 113 kann grundsätzlich auf beliebige geeignete Weise mit einem oder mehreren Stützelementen gestaltet sein. Im vorliegenden Beispiel ist die Stützeinrichtung in Form einer Schwingungsentkopplungseinrichtung 113 ausgeführt, über die der Metrologie-Rahmen 111.2 schwingungsisoliert bzw. schwingungsentkoppelt auf der lasttragenden Struktur 111.1 abgestützt. Dies geschieht über eine Mehrzahl von Stützelementen in Form von Stützfedereinrichtungen 113.1 der Schwingungsentkopplungseinrichtung 113, wobei die Stützfedereinrichtungen 113.1 kinematisch parallel zueinander zwischen der lasttragenden ersten Stützstruktur 111.1 und dem Metrologie-Rahmen 111.2 wirken. Jede der Stützfedereinrichtungen 113.1 definiert eine Stützkraftrichtung SFR, in der sie eine Stützkraft SF zwischen der ersten Stützstruktur 111.1 und der zweiten Stützstruktur 111.2 ausübt, sowie eine Stützlänge SL1 entlang der Stützkraftrichtung SFR.

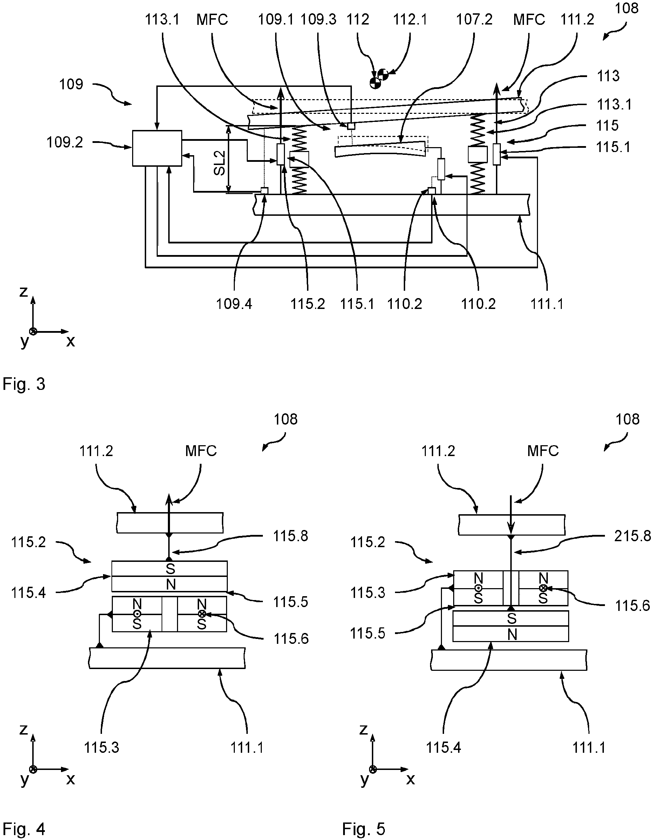

Während hiermit (auf kurzen Zeitskalen) eine gute dynamische Schwingungsisolierung bzw. Schwingungsentkopplung des Metrologie-Rahmens 111.2 von der lasttragenden ersten Stützstruktur 111.1 erreicht werden kann, hat es sich jedoch gezeigt, dass es auf langen Zeitskalen im Bereich der Schwingungsentkopplungseinrichtung 113, insbesondere im Bereich der Stützfedereinrichtungen 113.1, zu so genannten Kriecheffekten bzw. Setzeffekten kommen kann. Hierdurch ändert sich langfristig die Stützlänge der Stützfedereinrichtungen 113.1 (wie dies in Figur 3 und 4 durch die Länge SL2 angedeutet ist) und damit sowohl die Lage des Metrologie-Rahmens 111.2 als auch die Lage der für die Ansteuerung der Lageregeleinrichtung 110 verwendeten Referenz 112 bezüglich der lasttragenden Struktur 111.1 (gegenüber der in Figur 3 durch die Kontur 112.1 angedeuteten Ausgangslage), wie dies (stark übertrieben) in Figur 3 dargestellt ist. Eine solche Lageänderung der Referenz 112 kann im Normalbetrieb der Abbildungseinrichtung 101 grundsätzlich durch die Lageregeleinrichtung 110 kompensiert werden, indem die optischen Elemente der Elementgruppe 107.1 der Referenz 112 nachgeführt werden (wie dies in Figur 3 dargestellt ist). Eine solche Kompensation der Lageänderung der Referenz 112 durch die Lageregeleinrichtung 110 über die Lebensdauer der Abbildungseinrichtung 101 würde jedoch ausreichende Verfahrwege, mithin also eine ausreichende Bewegungsreserve der Lageregeleinrichtung 110 erfordern, wodurch diese entsprechend aufwändig bzw. teuer gestaltet sein müsste.

Um dies möglichst weit gehend zu vermeiden, ist im vorliegenden Beispiel eine Reduktionseinrichtung bzw. Kompensationseinrichtung 115 zur Reduktion bzw. zumindest teilweisen Kompensation einer solchen Änderung der statischen Relativlage zwischen der ersten Stützstruktur 111.1 und der zweiten Stützstruktur 111.2 in wenigstens einem Korrekturfreiheitsgrad vorgesehen. Die Reduktionseinrichtung bzw. Kompensationseinrichtung 115 umfasst eine kinematisch parallel zu den Stützfedereinrichtungen zwischen der ersten Stützstruktur und der zweiten Stützstruktur wirkende, passive oder aktiv ansteuerbare Magneteinrichtung 115.1 mit einer Reihe von Magneteinheitenpaaren 115.2, die gegebenenfalls (also im Fall einer aktiven Gestaltung) von der Steuereinheit 109.2 angesteuert werden können. Die Magneteinrichtung 115.1 übt im vorliegenden Beispiel in dem ersten Betriebsmodus OM1 eine erste Magnetstützkraft MFT1 auf den Metrologie-Rahmen 111.2 aus, welche die Resultierende der einzelnen Magnetkraftbeiträge MFC der Magneteinheitenpaare 115.2 ist. Wie nachfolgend noch näher erläutert wird, kann die Magnetstützkraft MFT zur gegebenenfalls sogar vollständigen Kompensation der Relativlageänderung seitens der Steuereinheit verändert werden.

Hierzu kann die Steuereinrichtung 109 im vorliegenden Beispiel eine für eine Änderung der statischen Relativlage zwischen der lasttragenden ersten Stützstruktur 110.1 und der zweiten Stützstruktur 110.2 in wenigstens einem Freiheitsgrad repräsentative Relativlageänderungsinformation RSCI erfassen. Die Steuereinrichtung 109 weist einen Kompensationsmodus CCM (im Folgenden auch als Kriechkompensationsmodus CCM bezeichnet) auf, in dem die dann aktive Magneteinrichtung 115.1 von der Steuereinheit 109.2 angesteuert wird, um die Magnetkraftbeiträge AFC der aktiven Magneteinheitenpaare 115.2 und damit die Magnetstützkraft MFT in Abhängigkeit von der Relativlageänderungsinformation RSCI in eine zweite Magnetstützkraft MFT2 zu ändern. Die zweite Magnetstützkraft MFT2 ist dabei so gewählt, dass der Metrologie-Rahmen 111.2 wieder in den in Figur 2 dargestellten Ausgangszustand verbracht wird. Die aktive Magneteinrichtung 115.1 übt dann in einem dem Kompensationsmodus CCM nachfolgenden zweiten Betriebsmodus OM2 die zweite Magnetstützkraft MFT2 auf die den Metrologie-Rahmen 111.2 aus.

Es versteht sich, dass für die Ansteuerung der Magneteinrichtung 115.1 sowohl ein geschlossener Regelkreis realisiert sein kann (bei dem die Relativlageänderungsinformation RSCI über entsprechende Erfassungssignale tatsächlich erfasst wird) als auch eine offene Steuerstrecke realisiert sein kann (bei dem die Relativlageänderungsinformation RSCI beispielsweise über ein entsprechendes Modell ermittelt wird), wie dies nachfolgend noch näher erläutert wird.

Mit dieser Korrektur bzw. Kompensation ist es zum Beispiel in einfacher und vorteilhafter Weise möglich, den Metrologie-Rahmen 111.2, die Referenz 12 und damit die Lageregeleinrichtung 110 (und die von ihr getragenen optischen Elemente der Elementgruppe 107.1, wie beispielsweise das optische Element 107.2) nach einer bestimmten längeren Betriebszeit (über die sich Kriech- oder Setzeffekte in der Abstützung der zweiten Stützstruktur 110.2 spürbar ausgewirkt haben) wieder in ihren Ausgangszustand (oder in dessen Nähe) zurückzusetzen, den sie nach einer initialen Justage der Abbildungseinrichtung (typischerweise unmittelbar bei erstmaliger Inbetriebnahme der Abbildungseinrichtung 101), mithin also in dem ersten Betriebszustand OM1 innehatte.

Hiermit ist es insbesondere in einfacher und vorteilhafter Weise möglich, den maximal erforderlichen bzw. möglichen Verfahrweg der Lageregeleinrichtung 110 vergleichsweise gering zu halten bzw. auf das Nötigste zu beschränken. Insbesondere ist keine große Bewegungsreserve für die Kompensation langfristiger Kriech- oder Setzeffekte durch die Lageregeleinrichtung 110 vorzuhalten. Diese Bewegungsreserve kann deutlich kleiner gehalten werden und sich beispielsweise auf einen für die Dauer des ersten Betriebsmodus OM1 zu erwartenden Wert beschränken.

Es versteht sich, dass das Ändern der Magnetstützkraft MFT beliebig oft wiederholt werden kann, mithin also beliebig oft in den Kriechkompensationsmodus CCM geschaltet werden kann. Hiermit ist es möglich, über die gesamte Lebensdauer der Abbildungseinrichtung 101 ein entsprechend günstiges Betriebsverhalten zu erzielen.

Weiterhin ist es bei passiven Varianten (d. h. Varianten ohne aktive Veränderung der Magnetstützkraft) möglich durch eine entsprechende Gestaltung des Magneteinheitenpaares 115.2 eine vorteilhafte Reduktion der Relativlageänderung zu erzielen. Besonders einfache, insoweit passive Konfigurationen ergeben sich, wenn wenigstens eine Magneteinheit des Magneteinheitenpaares 115.2 wenigstens einen Permanentmagneten umfasst. Dabei können in besonders einfachen Fällen die beiden Magneteinheiten eines Magneteinheitenpaares 115.2 der Magneteinrichtung 115.1 jeweils wenigstens einen Permanentmagneten umfassen. Solche Konfigurationen zeichnen sich dann durch eine besonders einfache Gestaltung und einen überproportionalen Verlauf des Magnetkraftbeitrags MFC in Abhängigkeit vom Abstand der beiden Magneteinheiten aus.

Bei weiteren Varianten kann wenigstens eine erste Magneteinheit eines Magneteinheitenpaares der Magneteinrichtung eine Mehrzahl von Permanentmagneten umfassen, deren Magnetfelder einander derart überlagert sind, dass in Richtung des Magnetkraftbeitrags MFC zur Magnetstützkraft MFT, der durch das Magneteinheitenpaar erzeugt wird, über einen vorgebbaren Bewegungsabschnitt ein Magnetkraftbeitrag MFC mit einem vorgebbaren Verlauf auf eine zweite Magneteinheit eines Magneteinheitenpaares 115.2 wirkt.

Dabei kann insbesondere über einen vorgebbaren Bewegungsabschnitt eine im Wesentlichen konstante Magnetkraft realisiert sein. Das Magneteinheitenpaar 115.2 weist in diesem Fall dann eine Steifigkeit zumindest nahe Null auf, was unter dynamischen Gesichtspunkten besonders vorteilhaft sein kann, da das dynamische Schwingungsentkopplungsverhalten dann insoweit primär bzw. sogar ausschließlich über die Stützfedereinrichtungen 113.1 definiert wird.

Bei bestimmten Varianten kann vorgesehen sein, dass die Magneteinrichtung 115.1 derart ausgebildet ist, dass die Magnetstützkraft MFT mit zunehmender Relativlageänderung zumindest abschnittsweise proportional zunimmt. Insbesondere kann die Magneteinrichtung 115.1 derart ausgebildet sein, dass die Magnetstützkraft MFT mit zunehmender Relativlageänderung zumindest abschnittsweise überproportional zunimmt. Beide Varianten sind natürlich auf die Stützfedereinrichtungen 113.1 abgestimmt und führen in vorteilhafter Weise zu der oben bereits beschriebenen Reduktion der statischen Relativauslenkung.

Die Relativlageänderung bzw. die zugehörige Relativlageänderungsinformation RSCI kann bei aktiven Varianten grundsätzlich auf beliebige geeignete Weise ermittelt werden. So kann die Lageregeleinrichtung 110 beispielsweise eine mit der Steuereinheit 109.2 verbundene Auslenkungserfassungseinrichtung 110.2 umfassen. Die Auslenkungserfassungseinrichtung 110.2 erfasst eine Auslenkungsinformation DI, die für eine Auslenkung des optischen Elements 107.2 bezüglich der ersten Stützstruktur 111.1 in wenigstens einem Freiheitsgrad aus dem ersten Ausgangszustand repräsentativ ist. Die Steuereinrichtung 109 leitet aus der Auslenkungsinformation DI, insbesondere in Abhängigkeit von einer zeitlichen Änderung der Auslenkungsinformation DI, dann die Relativlageänderungsinformation RSCI ab.

So kann die Lageregeleinrichtung 110 zur aktiven Verstellung des optischen Elements 107.2 eine Reihe von Lageregelaktuatoren 110.1 umfassen, von denen aus Gründen der Übersichtlichkeit in den Figuren 2 und 3 jeweils nur ein Lageregelaktuator 110.1 dargestellt ist. Bei typischen Varianten sind mehrere Lageregelaktuatoren 110.1 vorgesehen, die nach Art einer Parallelkinematik zwischen der ersten Stützstruktur 111.1 und dem optischen Element 107.1 wirken. Beispielsweise können sechs Lageregelaktuatoren 110.1 vorgesehen sein, die nach Art einer Hexapod-Kinematik wirken.

Eine Auslenkungserfassungseinrichtung 110.2 kann beispielsweise eine Verstellinformation VI erfassen, die für eine Verstellung des jeweiligen Lageregelaktuators 110.1 aus dem justierten ersten Ausgangszustand repräsentativ ist. Die Steuereinrichtung 109.1 kann dann aus der Verstellinformation VI, insbesondere in Abhängigkeit von einer zeitlichen Änderung der Verstellinformation VI, die Relativlageänderungsinformation RSCI ableiten.

Weiterhin kann die Auslenkungserfassungseinrichtung 110.2 wenigstens einen Verstellsensor 110.3 umfassen, der dem jeweiligen Lageregelaktuator 110.1 zugeordnet ist. Der Verstellsensor 110.3 gibt eine für die Stellbewegung des Lageregelaktuators 110.1, insbesondere eine Längenänderung des Lageregelaktuators 110.1, repräsentative Verstellsensorinformation VSI aus. Die Steuereinrichtung 109 kann dann aus der Verstellsensorinformation VSI die Verstellinformation VI ableiten. Dabei versteht es sich, dass grundsätzlich beliebig viele Verstellsensoren 110.3 je Lageregelaktuator 110.1 vorgesehen sein können, um die Verstellinformation VI zu ermitteln. Im vorliegenden Beispiel sind dem jeweiligen Lageregelaktuator 110.1 wenigstens zwei Verstellsensoren 110.3 zugeordnet, da hiermit eine besonders zuverlässige, fehlertolerante Ermittlung der Verstellinformation VI möglich ist.

Es versteht sich jedoch, dass die Verstellinformation VI bei anderen Varianten (zusätzlich oder alternativ zu der Verwendung der Verstellsensoren 110.3) grundsätzlich auch auf beliebige andere geeignete Weise erfasst werden kann. So kann beispielsweise vorgesehen sein, beginnend mit dem ersten Ausgangszustand die Steuersignale für den jeweiligen einen Lageregelaktuator 110.2 lückenlos in einer Historie zu erfassen bzw. nachzuhalten und aus dieser Historie der Steuersignale die Verstellinformation VI zu ermitteln.

Bei bestimmten Varianten kann die Steuereinrichtung 109 gegebenenfalls auch eine (nicht näher dargestellte) Abbildungsfehlererfassungseinrichtung umfassen, die wenigstens eine für einen Abbildungsfehler der Abbildungseinrichtung repräsentative Abbildungsfehlerinformation IEI erzeugt. Die Steuereinrichtung 109 leitet dann aus der Abbildungsfehlerinformation IEI, insbesondere in Abhängigkeit von einer zeitlichen Änderung der Abbildungsfehlerinformation IEI, die Relativlageänderungsinformation RSCI. Diese Varianten nutzen in vorteilhafter Weise einen bekannten Zusammenhang zwischen dem Abbildungsfehler der Abbildungseinrichtung und der durch Kriech- bzw. Setzeffekte bedingten statischen Relativlageänderung zwischen der ersten Stützstruktur 111.1 und der zweiten Stützstruktur 111.2. So können bestimmte Relativlageänderungen charakteristische Abbildungsfehler hervorrufen, mithin also einen charakteristischen Fingerabdruck aufweisen, der zuvor theoretisch und/oder durch simulatorisch ermittelt wurde. Diese charakteristischen Abbildungsfehler bzw. Fingerabdrücke können dann genutzt werden, um im Betrieb in der Steuereinrichtung 109 auf eine tatsächliche Relativlageänderung zu schließen.

Ein besonders deutlicher Zusammenhang zwischen dem Abbildungsfehler und einer solchen Relativlageänderung ergibt sich insbesondere bei Varianten, bei denen die optische Abbildungseinrichtung 101 auch passive optische Komponenten umfasst, die an der Abbildung beteiligt sind, jedoch nicht aktiv über die Lageregeleinrichtung 110 eingestellt werden, sondern im Betrieb im Wesentlichen starr mit der ersten Stützstruktur 111.1 verbunden sind, wie dies in Figur 1 durch die Kontur 107.3 angedeutet ist, die eine Blende repräsentiert. In diesem Fall werden nur die aktiv eingestellten optischen Elemente der Elementgruppe 107.1 durch die Lageregeleinrichtung 110 der Relativlageänderung nachgeführt, während die passiven Komponenten, wie die Blende 107.3, in ihrer Lage verbleiben und sich damit eine Lageänderung zwischen den optischen Komponenten 107.1 und 107.3 ergibt, die einen charakteristischen Abbildungsfehler nach sich zieht.

Bei weiteren Varianten kann die Steuereinrichtung 109 zusätzlich oder alternativ eine Relativlageerfassungseinrichtung umfassen, wie sie in Figur 2 durch die Kontur 109.4 angedeutet ist. Die Relativlageerfassungseinrichtung 109.4 erzeugt dabei wenigstens eine für die Relativlage zwischen der ersten Stützstruktur 111.1 und der zweiten Stützstruktur 111.2 in wenigstens einem Freiheitsgrad repräsentative Relativlageinformation RSI, die an die Steuereinheit 109.2 ausgegeben wird. Die Steuereinrichtung 109 ist leitet dann aus der Relativlageinformation RSI, insbesondere in Abhängigkeit von einer zeitlichen Änderung der Relativlageinformation RSI, die Relativlageänderungsinformation RSCI ab. Hiermit kann eine besonders einfache und präzise Erfassung der Relativlageänderungsinformation RSCI realisiert werden.

Während die vorstehend beschriebenen aktiven Varianten jeweils einen geschlossenen Regelkreis realisieren, kann wie erwähnt auch eine Variante mit einer offenen Steuerstrecke realisiert sein. So kann bei bestimmten Varianten die Steuereinrichtung 109 bei bestimmten Varianten zur Ermittlung der Relativlageänderungsinformation RSCI auch Zustandsänderungsmodell CM der Stützeinrichtung 113 verwenden, wobei das Zustandsänderungsmodell CM insbesondere zeitabhängig sein kann (beispielsweise um Alterungsprozesse innerhalb der Stützeinrichtung 113 abzubilden). Das Zustandsänderungsmodell CM beschreibt dabei ein (insbesondere zeitabhängiges) Lageänderungsverhalten der Stützeinrichtung 113. Im vorliegenden Beispiel kann das Zustandsänderungsmodell ein Kriechmodell CM der Stützfedereinrichtung 113 verwenden, wobei das Kriechmodell CM der Stützfedereinrichtung 113 das (gegebenenfalls zeitabhängige) Kriechverhalten der Stützfedereinrichtung 113 beschreibt. Aus diesem mit ausreichender Genauigkeit bekannten Lageänderungsverhalten bzw. Kriechverhalten kann die Relativlageänderungsinformation RSCI dann gegebenenfalls ohne weitere Sensorik ermittelt werden und unmittelbar für die Ansteuerung verwendet werden. Bei weiteren Varianten kann das Zustandsänderungsmodell bzw. Kriechmodell CM aber auch für eine Plausibilitätsprüfung der Relativlageänderungsinformation RSCI verwendet werden, welche auf eine andere vorstehend oder nachfolgend beschriebene Weise ermittelt wurde.

Es sei an dieser Stelle nochmals erwähnt, dass die vorstehend oder nachfolgend beschriebenen Varianten zur Ermittlung der Relativlageänderungsinformation RSCI grundsätzlich auf beliebige Weise kombiniert werden können, um beispielsweise eine konsolidierte (beispielsweise gemittelte) Relativlageänderungsinformation RSCI zu erlangen. Zusätzlich oder alternativ können natürlich auch einzelne Varianten der Ermittlung der Relativlageänderungsinformation RSCI zur Plausibilitätsprüfung der Ergebnisse der anderen Varianten der Ermittlung der Relativlageänderungsinformation RSCI verwendet werden.

Die Änderung der Magnetstützkraft MFT kann weiterhin grundsätzlich zu beliebigen geeigneten Zeitpunkten bzw. ausgelöst durch beliebige zeitliche Ereignisse (beispielsweise vorgebbare Intervalle) und/oder nicht-zeitliche Ereignisse (beispielsweise erfasste Schocklasten, Erreichen einer bestimmten Anzahl von Abbildungsvorgängen, das Starten oder Herunterfahren der Abbildungseinrichtung 101 etc.) erfolgen.

Im vorliegenden Beispiel aktiviert die Steuereinrichtung 109 den Kriechkompensationsmodus CCM, wenn die durch die Relativlageänderungsinformation RSCI repräsentierte Relativlageänderung einen vorgebbaren Grenzwert LIM überschreitet (d.h. wenn gilt: RSCI > LIM). Hiermit kann natürlich besonders effizient und bedarfsgerecht auf die Kriech- bzw. Setzeffekte reagiert werden.

Zusätzlich oder alternativ kann die Steuereinrichtung 109 den Kriechkompensationsmodus bzw. Kompensationsmodus CCM wie erwähnt in Abhängigkeit von vorgebbaren Ereignissen, insbesondere in vorgebbaren zeitlichen Intervallen, aktivieren, wobei der Kriechkompensationsmodus insbesondere 0,25 bis 10 Jahre, vorzugsweise 0,5 bis 5 Jahre, weiter vorzugsweise 1 bis 2 Jahre, nach einem Betriebsbeginn der Abbildungseinrichtung 101 und/oder einer vorhergehenden Antivierung des Kriechkompensationsmodus CCM aktiviert wird.

Die Steuereinrichtung 109 kann grundsätzlich auf beliebige geeignete Weise gestaltet sein, eine dem jeweiligen optischen Abbildungsprozess der Abbildungseinrichtung 101 angepasste Ansteuerung der Lageregeleinrichtung 110 zu realisieren. Dabei können beliebige geeignete Regelbandbreiten für die Ansteuerung der Lageregeleinrichtung 110 vorgesehen sein. Bei besonders vorteilhaften Varianten weist die Steuereinrichtung 109 eine Regelbandbreite von 10 Hz bis 1000 Hz, vorzugsweise 20 Hz bis 500 Hz, weiter vorzugsweise 50 Hz bis 300 Hz, auf. Bei dem Freiheitsgrad bzw. den Freiheitsgraden DOF, in denen eine für den Abbildungsprozess bzw. dessen Abbildungsfehler relevante Relativlageänderung durch Kriech- bzw. Setzeffekte erfolgt, kann es sich um beliebige Freiheitsgrade bis hin zu allen sechs Freiheitsgraden im Raum handeln. Dabei können beliebige geeignete Grenzwerte vorgegeben sein, bei deren Überschreitung eine Änderung der Magnetstützkraft MFT erforderlich bzw. vorgenommen wird.

Bei bestimmten Varianten ist der wenigstens eine Freiheitsgrad DOF der Relativlageänderung ein Rotationsfreiheitsgrad, insbesondere ein Rotationsfreiheitsgrad um eine quer zu der Gravitationsrichtung verlaufende Kippachse. Der vorgebbare Grenzwert ist dann bevorzugt für eine Abweichung der Relativlage zwischen der ersten Stützstruktur 111.1 und der zweiten Stützstruktur 111.2 von einer vorgebbaren Relativsolllage um 1 µrad bis 500 µrad, vorzugsweise 10 µrad bis 300 µrad, weiter vorzugsweise 20 µrad bis 100 µrad, repräsentativ. Zusätzlich oder alternativ kann der wenigstens eine Freiheitsgrad DOF der Relativlageänderung ein Translationsfreiheitsgrad sein, insbesondere ein Translationsfreiheitsgrad entlang der Gravitationsrichtung. Der vorgebbare Grenzwert ist dann bevorzugt für eine Abweichung der Relativlage zwischen der ersten Stützstruktur 111.1 und der zweiten Stützstruktur 111.2 von einer vorgebbaren Relativsolllage um 1 µm bis 500 µm, vorzugsweise 10 µm bis 300 µm, weiter vorzugsweise 20 µm bis 100 µm, repräsentativ.

Die Magneteinrichtung 115.1 kann grundsätzlich auf beliebige geeignete Weise gestaltet sein, um die Magnetstützkraft MFT zu erzeugen. Bevorzugt ist die Steifigkeit der Magneteinrichtung 115.1 natürlich auf die Steifigkeit der Stützfedereinrichtungen 113.1 abgestimmt, um die gewünschte Entkopplungswirkung der Schwingungsentkopplungseinrichtung 113 in den erforderlichen Entkopplungsfreiheitsgraden zu erzielen. Bevorzugt ist die Magneteinrichtung 115.1 so gestaltet, dass sie in diesen Entkopplungsfreiheitsgraden, in denen die Schwingungsentkopplungseinrichtung 113 eine Entkopplung bereitstellen soll, einen möglichst geringen Beitrag zur Steifigkeit der Abstützung der Metrologie-Rahmens 111.2 liefert. Vorzugsweise liefert die Magneteinrichtung 115.1 in diesen Entkopplungsfreiheitsgraden im Wesentlichen keinen Beitrag zur Steifigkeit der Abstützung des Metrologie-Rahmens 111.2.

Das Zusammenspiel zwischen den Stützfedereinrichtungen 113.1 und der Magneteinrichtung 115.1 kann grundsätzlich auf beliebige geeignete Weise gestaltet sein, um die gewünschte schwingungsentkoppelte Abstützung des Metrologie-Rahmens 111.2 zu erzielen. So kann die Magneteinrichtung 115.1 derart ausgebildet sein, dass die Magnetstützkraft MFT die Stützfedereinrichtungen 113.1 zumindest teilweise entlastet und die Magnetstützkraft MFT zur zumindest teilweisen Kompensation der Relativlageänderung passiv oder aktiv erhöht wird, wie dies nach folgend noch im Zusammenhang mit den Figuren 4 und 6 beschrieben wird. Ebenso kann die Magneteinrichtung 115.1 aber auch derart ausgebildet sein, dass die Magnetstützkraft MFT die Stützfedereinrichtungen 113.1 vorspannt und die Magnetstützkraft MFT zur zumindest teilweisen Kompensation der Relativlageänderung verringert wird, wie dies nach folgend noch im Zusammenhang mit Figur 5 beschrieben wird.

Bei den Varianten der Figuren 4 und 6 ist die Magneteinrichtung 115.1 zur Entlastung der Stützfedereinrichtungen 113.1 derart ausgebildet, dass die Magnetstützkraft MFT wenigstens einen Anteil der Gesamtgewichtskraft des Metrologie-Rahmens 111.2 und der davon getragenen Komponenten (wie der Messeinrichtung 109.1) ausgleicht. Besonders vorteilhaft ist es, wenn dieser Anteil wenigstens 0,5% bis 20%, vorzugsweise wenigstens 1% bis 15%, weiter vorzugsweise wenigstens 2% bis 5%, der Gesamtgewichtskraft beträgt. Dabei kann es insbesondere günstig sein, wenn zumindest ein Großteil der Gewichtskraft durch die Magnetstützkraft MFT aufgenommen wird, die Stützfedereinrichtungen 113.1 mithin also von den statischen Lasten erheblich entlastet werden und es aufgrund dieser Entlastung auch zu verringerten Kriech- bzw. Setzeffekten kommt.

Zur Erzeugung der Magnetstützkraft MFT können grundsätzlich beliebige geeignete Magneteinheitenpaare 115.2 verwendet werden. Bei den nachfolgend im Zusammenhang mit den Figuren 4 bis 7 beschriebenen Beispielen umfasst die Magneteinrichtung 115.1 jeweils eine Reihe von Magneteinheitenpaaren 115.2 mit zwei jeweils permanent magnetisierten Magneteinheiten 115.3 und 115.4.

Wie nachfolgend zunächst anhand der Variante aus Figur 4 beschrieben wird, umfasst das Magneteinheitenpaar 115.2 eine permanent magnetisierte erste Magneteinheit 115.3 und eine permanent magnetisierte zweite Magneteinheit 115.4, die einander zum berührungslosen Zusammenwirken mit einem dazwischenliegenden Luftspalt 115.5 zugeordnet sind. Dabei ist die erste Magneteinheit 115.3 mechanisch mit der lasttragenden ersten Stützstruktur 111.1 verbunden, während die zweite Magneteinheit 115.4 mechanisch mit dem Metrologie-Rahmen 111.2 verbunden ist.

Die erste Magneteinheit 115.3 kann dabei in einer aktiven Variante eine schematisch angedeutete Spuleneinheit 115.6 umfassen, die zur Veränderung der Magnetisierung der ersten Magneteinheit 115.3 mit einer (nicht dargestellten) Spannungsquelle der Steuereinrichtung 109 verbindbar ist. Hiermit ist es in besonders einfacher Weise möglich, die magnetische Feldstärke der ersten Magneteinheit 115.3 und damit den Magnetkraftbeitrag MFC bzw. in Summe die Magnetstützkraft MFT über eine entsprechende Ansteuerung der Spuleneinheit 115.6 anzupassen.

Die Magnetisierung der ersten Magneteinheit 115.3 und der zweiten Magneteinheit 115.4 ist in der Variante aus Figur 4 so gewählt, dass der Beitrag MFC zu der Magnetstützkraft MFT aus einer gegenseitigen Abstoßung der ersten Magneteinheit 115.3 und der zweiten Magneteinheit 115.4 resultiert. Die erste Magneteinheit 115.3 und die zweite Magneteinheit 115.4 trachten also danach, den Luftspalt 115.5 zwischen der ersten Magneteinheit 115.4 und der zweiten Magneteinheit 115.5 zu vergrößern.

Eine solche Anordnung weist typischerweise einen Kraftverlauf auf, bei dem mit einer Verringerung des Luftspaltes 115.5 der Kraftbeitrag MFC des Magneteinheitenpaars 115.1 zu der Magnetstützkraft MFT mit zunehmender Relativlageänderung zumindest abschnittsweise überproportional zunimmt. Hiermit kann in vorteilhafter Weise einer Relativlageänderung ein stark zunehmender Widerstand durch den Kraftbeitrag MFC bzw. die resultierende Magnetstützkraft MFT entgegengesetzt werden, sodass die Relativlageänderung, die sich andernfalls aus Kriech- oder Setzvorgängen in den Stützfedereinrichtungen 113.1 ergäbe, selbst bei passiver Gestaltung des Magneteinheitenpaars 115.1 zumindest teilweise ausgeglichen bzw. reduziert werden kann. Bei einer aktiven Variante des Magneteinheitenpaars 115.1 kann sogar der Ausgangszustand über eine entsprechende Ansteuerung über die Steuereinheit 109.2 wiederhergestellt werden.

Das Magneteinheitenpaar 115.2 kann grundsätzlich so gestaltet sein, dass sie bereits selbst die erforderliche Entkopplung in den (für die Abstützung der zweiten Stützstruktur 111.2) erforderlichen Entkopplungsfreiheitsgraden zur Verfügung stellt. Im vorliegenden Beispiel ist das Magneteinheitenpaar 115.2 über eine Entkopplungseinrichtung 115.8 mechanisch mit der zweiten Stützstruktur 111.2 verbunden. Die die Entkopplungseinrichtung 115.8 ist dabei dazu ausgebildet, in mehreren von der Magnetkraftrichtung der Kraft MFC verschiedenen Entkopplungsfreiheitsgraden eine zumindest teilweise mechanische Entkopplung zwischen der Magneteinheitenpaar 115.2 und der Stützstruktur 111.2 zu erzeugen. Im vorliegenden Beispiel handelt es sich bei einem Entkopplungsfreiheitsgrad um einen translatorischen Freiheitsgrad, der quer zu der Magnetkraftrichtung verläuft. Zusätzlich besteht eine Entkopplung in einem rotatorischen Freiheitsgrad um eine Achse, die quer zu der Magnetkraftrichtung verläuft. In allen diesen Fällen kann auf einfache Weise eine günstige Schwingungsentkopplung erzielt werden.

Die Entkopplungseinrichtung 115.8 ist hierzu als in der Magnetkraftrichtung langgestrecktes biegeweiches Entkopplungselement ausgebildet, nämlich als in der Magnetkraftrichtung langgestrecktes Blattfederelement oder als in der Magnetkraftrichtung langgestrecktes und schlankes, insbesondere biegeweiches, Stabfederelement. In beiden Fällen kann in einfacher Weise die gewünschte Entkopplung erzielt werden.

In der Variante der Figur 4 ist die Magneteinrichtung 115.1 derart ausgebildet, dass die Magnetstützkraft MFT die Stützfedereinrichtungen 113.1 zumindest teilweise entlastet und die Magnetstützkraft MFT zur zumindest teilweisen Kompensation der Relativlageänderung erhöht wird, wie dies bereits beschrieben wurde.

In der nachfolgend beschriebenen Variante der Figur 5 ist die Magneteinrichtung 115.1 jedoch derart ausgebildet, dass die Magnetstützkraft MFT die Stützfedereinrichtungen 113.1 vorspannt und die Magnetstützkraft MFT zur zumindest teilweisen Kompensation der Relativlageänderung verringert wird. Dabei entspricht die Variante der Figur 5 in ihrem grundsätzlichen Aufbau und ihrer Funktionsweise der Variante der Figur 4, sodass hier nur auf die Unterschiede eingegangen werden soll. Gleichartige Komponenten sind mit um den Wert 100 erhöhten Bezugszeichen versehen und es wird, soweit nicht explizit Anderweitiges ausgeführt wird, hinsichtlich der Eigenschaften dieser Komponenten ausdrücklich auf die Ausführungen zur Variante der Figur 4 verwiesen.

Der Unterschied der Variante aus Figur 5 zu der Variante aus Figur 4 besteht darin, dass die erste Magneteinheit 115.3 und die zweite Magneteinheit 115.4 des Magneteinheitenpaares 215.2 (im Vergleich zu dem Magneteinheitenpaar 115.2 aus Figur) umgekehrt angeordnet wurden, sodass die Magnetstützkraft MFT die Stützfedereinrichtungen 113.1 vorspannt und die Magnetstützkraft MFT zur zumindest teilweisen Kompensation der Relativlageänderung verringert wird. Hierzu wurde im Übrigen lediglich die Entkopplungseinrichtung 215.8 entsprechend angepasst.

Die nachfolgend beschriebene Variante der Figur 6 gleicht in ihrem grundsätzlichen Aufbau und der Variante der Figur 5, sodass hier nur auf die Unterschiede eingegangen werden soll. In der Variante der Figur 6 ist die Magneteinrichtung 115.1 wiederum derart ausgebildet, dass die Magnetstützkraft MFT die Stützfedereinrichtungen 113.1 entlastet, wobei die zweite Magneteinheit 115.4 umgedreht wurde, sodass die Magnetisierung der ersten Magneteinheit 115.3 und der zweiten Magneteinheit 115.4 so gewählt ist, dass der Beitrag MFC zu der Magnetstützkraft MFT aus einer gegenseitigen Anziehung der ersten Magneteinheit 115.3 und der zweiten Magneteinheit 115.4 resultiert. Die erste Magneteinheit 315.3 und die zweite Magneteinheit 315.4 trachten also danach, den Luftspalt 115.5 zwischen der ersten Magneteinheit 115.4 und der zweiten Magneteinheit 115.5 zu verringern.

Der Unterschied der Variante aus Figur 6 zu der Variante aus Figur 5 besteht darin, dass eine Kompensation der Relativlageänderung nur aktiv über die Spuleneinheit 115.6 erfolgt, die zur Veränderung der Magnetisierung der ersten Magneteinheit 115.3 mit einer (nicht dargestellten) Spannungsquelle der Steuereinrichtung 109 verbindbar ist. Hiermit ist es in besonders einfacher Weise möglich, die magnetische Feldstärke der ersten Magneteinheit 115.3 und damit den Magnetkraftbeitrag MFC bzw. in Summe die Magnetstützkraft MFT über eine entsprechende Ansteuerung der Spuleneinheit 115.6 zu erhöhen, um eine Kompensation zu erzielen.

Eine weitere Variante wird nachfolgend anhand der Figur 7 beschrieben. Dabei entspricht die Variante der Figur 7 in ihrem grundsätzlichen Aufbau und ihrer Funktionsweise der Variante der Figur 4, sodass hier nur auf die Unterschiede eingegangen werden soll. Gleichartige Komponenten sind mit um den Wert 200 erhöhten Bezugszeichen versehen und es wird, soweit nicht explizit Anderweitiges ausgeführt wird, hinsichtlich der Eigenschaften dieser Komponenten ausdrücklich auf die Ausführungen zur Variante der Figur 4 verwiesen.

Der Unterschied der Variante aus Figur 7 zu der Variante aus Figur 4 besteht darin, dass die erste Magneteinheit 315.3 des Magneteinheitenpaares 115.2 aus mehreren Magnetelementen 315.7 topfförmig aufgebaut ist. Dabei ist die jeweilige Magnetisierung so gewählt ist, dass sich ihre Magnetfeldlinien 315.9 so überlagern, dass der Beitrag MFC des Magneteinheitenpaares 115.2 zur Magnetstützkraft MFT über eine längere Strecke der Relativlageänderung nahezu konstant ist. Das Magneteinheitenpaar 115.2 weist in diesem Fall dann eine Steifigkeit zumindest nahe Null auf, was unter dynamischen Gesichtspunkten besonders vorteilhaft sein kann, da das dynamische Schwingungsentkopplungsverhalten dann insoweit primär bzw. sogar ausschließlich über die Stützfedereinrichtungen 113.1 definiert wird.

Es versteht sich, dass bei geeigneter Überlagerung der Magnetfeldlinien 315.9 auch ein nahezu beliebiger anderer Verlauf des Beitrags MFC des Magneteinheitenpaares 115.2 zur Magnetstützkraft MFT über die Relativlageänderung erzielt werden kann.

Weiterhin versteht es sich, dass grundsätzlich innerhalb der Magneteinrichtung 115 grundsätzlich auch die unterschiedlichen Magneteinheitenpaare 115.2 (der Figuren 4 bis 7) beliebig miteinander kombiniert werden können. Insbesondere kann die jeweilige Magneteinheitenpaar 115.2 dabei speziell auf die zugeordnete Stützfedereinrichtung 113.1 und deren Kriechverhalten bzw. auf deren Lastsituation aufgrund der Massenverteilung der abgestützten zweiten Stützstruktur 111.2 abgestimmt sein.

Mit den vorstehend beschriebenen aktiven Gestaltungen lässt sich das erfindungsgemäße Verfahren in der oben beschriebenen Weise ausführen. Dabei wird wie in Figur 8 gezeigt zunächst in einem Schritt 114.1 der Verfahrensablauf gestartet. Dies geschieht beispielsweise mit erstmaliger Inbetriebnahme der Abbildungseinrichtung 101, wobei sich die Abbildungseinrichtung dann in dem ersten Betriebszustand OM1 befindet.

In einem Schritt 114.2 wird dann in der Steuereinrichtung 109 überprüft, ob eines der oben beschriebenen Ereignisse eingetreten ist, welches die Aktivierung des Kriechkompensationsmodus CCM auslöst. Ist dies nicht der Fall, wird diese Überprüfung wiederholt. Ist dies jedoch der Fall, wird in der Steuereinrichtung 109 in einem Schritt 114.3 in der oben beschriebenen Weise die Magnetstützkraft MFT geändert bzw. angepasst, wobei die Steuereinrichtung 109 die Abbildungseinrichtung 101 dann in den zweiten Betriebszustand OM2 versetzt (der dann an die Stelle des ersten Betriebszustands OM1 tritt). In einem Schritt 114.3 wird dann in der Steuereinrichtung 109 überprüft, ob der Verfahrensablauf beendet werden soll. Ist dies nicht der Fall, wird zum Schritt 114.2 zurück gesprungen. Andernfalls endet der Verfahrensablauf in einem Schritt 114.4. Im Übrigen wird hinsichtlich weiterer Details des Verfahrens zur Vermeidung von Wiederholungen auf die obigen Ausführungen verwiesen.

Die vorliegende Erfindung wurde vorstehend ausschließlich anhand von Beispielen beschrieben, bei denen die Lage jedes der optischen Elemente der Elementgruppe 107.1 bezüglich der zentralen Referenz 112 aktiv eingestellt wurde. Es versteht sich jedoch, dass bei anderen Varianten auch nur ein Teil (gegebenenfalls sogar nur eines) der optischen Elemente der Elementgruppe 107.1 unmittelbar bezüglich der zentralen Referenz 112 aktiv eingestellt werden kann, während die übrigen optischen Elemente der Elementgruppe 107.1 relativ zu einem dieser bezüglich der zentralen Referenz 112 aktiv eingestellten optischen Elemente aktiv eingestellt werden. Insbesondere kann nur eines der optischen Elemente der Elementgruppe 107.1 als Referenzelement dienen und unmittelbar bezüglich der zentralen Referenz 112 aktiv eingestellt werden, während alle übrigen optischen Elemente der Elementgruppe 107.1 relativ zu diesem Referenzelement (und damit also nur mittelbar bezüglich der zentralen Referenz 112) aktiv eingestellt werden.

Die vorliegende Erfindung wurde vorstehend ausschließlich anhand von Beispielen aus dem Bereich der Mikrolithographie beschrieben. Es versteht sich jedoch, dass die Erfindung auch im Zusammenhang mit beliebigen anderen optischen Anwendungen, insbesondere Abbildungsverfahren bei anderen Wellenlängen, zum Einsatz kommen kann, bei denen sich ähnliche Probleme hinsichtlich der Abstützung schwerer optischer Einheiten stellen.

Weiterhin kann die Erfindung im Zusammenhang mit der Inspektion von Objekten, wie beispielsweise der so genannten Maskeninspektion zu Einsatz kommen, bei welcher die für die Mikrolithographie verwendeten Masken auf ihre Integrität etc. untersucht werden. An Stelle des Substrats 105.1 tritt dann in Figur 1 beispielsweise eine Sensoreinheit, welche die Abbildung des Projektionsmusters der Maske 104.1 (zur weiteren Verarbeitung) erfasst. Diese Maskeninspektion kann dann sowohl im Wesentlichen bei derselben Wellenlänge erfolgen, die im späteren Mikrolithographieprozess verwendet wird. Ebenso können aber auch beliebige hiervon abweichende Wellenlängen für die Inspektion verwendet werden.

Die vorliegende Erfindung wurde vorstehend schließlich anhand konkreter Ausführungsbeispiele beschrieben, welche konkrete Kombinationen der in den nachfolgenden Patentansprüchen definierten Merkmale zeigen. Es sei an dieser Stelle ausdrücklich darauf hingewiesen, dass der Gegenstand der vorliegenden Erfindung nicht auf diese Merkmalskombinationen beschränkt ist, sondern auch sämtliche übrigen Merkmalskombinationen, wie sie sich aus den nachfolgenden Patentansprüchen ergeben, zum Gegenstand der vorliegenden Erfindung gehören.

## Patentansprüche

1. Anordnung einer optischen Abbildungseinrichtung für die Mikrolithographie, insbesondere für die Verwendung von Licht im extremen UV-Bereich (EUV), mit
- einer ersten Stützstruktur (111.1) und
- einer zweiten Stützstruktur (111.2),
wobei
- die erste Stützstruktur (111.1) dazu ausgebildet ist, wenigstens ein optisches Element (107.2) der Abbildungseinrichtung abzustützen,
- die erste Stützstruktur (111.1) die zweite Stützstruktur (111.2) über eine Stützeinrichtung(113) abstützt,
- die zweite Stützstruktur (111.2) eine Messeinrichtung (109.1) abstützt, die zum Messen der Position und/oder Orientierung des wenigstens einen optischen Elements bezüglich einer Referenz (112), insbesondere einer Referenz (112) der zweiten Stützstruktur (111.2), in wenigstens einem Freiheitsgrad bis hin zu allen sechs Freiheitsgraden im Raum ausgebildet ist,
**dadurch gekennzeichnet, dass**
- eine Reduktionseinrichtung (115) zur Reduktion einer Änderung einer statischen Relativlage zwischen der ersten Stützstruktur (111.1) und der zweiten Stützstruktur (111.2) in wenigstens einem Korrekturfreiheitsgrad vorgesehen ist,
wobei
- die Reduktionseinrichtung (115) eine kinematisch parallel zu der Stützeinrichtung (113) zwischen der ersten Stützstruktur (111.1) und der zweiten Stützstruktur (111.2) wirkende Magneteinrichtung (115.1) umfasst, die dazu ausgebildet ist, eine der Relativlageänderung entgegenwirkende Magnetstützkraft auszuüben.

2. Anordnung nach Anspruch 1, wobei
- die erste Stützstruktur (111.1) die zweite Stützstruktur (111.2) über eine Mehrzahl von Stützfedereinrichtungen (113.1) einer Schwingungsentkopplungseinrichtung (113) der Stützeinrichtung abstützt,
- die Stützfedereinrichtungen (113.1) kinematisch parallel zueinander zwischen der ersten Stützstruktur (111.1) und der zweiten Stützstruktur (111.2) wirken,
- jede der Stützfedereinrichtungen (113.1) eine Stützkraftrichtung definiert, in der sie eine Stützkraft zwischen der ersten Stützstruktur (111.1) und der zweiten Stützstruktur (111.2) ausübt, sowie eine Stützlänge entlang der Stützkraftrichtung definiert und
- die Relativlageänderung durch eine Längenänderung wenigstens einer der Stützfedereinrichtungen (113.1) entlang ihrer Stützkraftrichtung bedingt ist, die sich aus einem Kriechprozess der Stützfedereinrichtung (113.1) ergibt, und
- die Magneteinrichtung (115.1) kinematisch parallel zu den Stützfedereinrichtungen (113.1) zwischen der ersten Stützstruktur (111.1) und der zweiten Stützstruktur (111.2) wirkt.

3. Anordnung nach Anspruch 1 oder 2, wobei
- die Magneteinrichtung (115.1) derart ausgebildet ist, dass sie wenigstens einen Anteil der Gesamtgewichtskraft der zweiten Stützstruktur (111.2) und der von der zweiten Stützstruktur (111.2) getragenen Komponenten aufnimmt,
wobei insbesondere
- der Anteil wenigstens 0,5% bis 20%, vorzugsweise wenigstens 1% bis 15%, weiter vorzugsweise wenigstens 2% bis 5%, der Gesamtgewichtskraft beträgt.

4. Anordnung nach einem der Ansprüche 1 bis 3, wobei
- die Magneteinrichtung (115.1) wenigstens ein Magneteinheitenpaar (115.2) aus zwei einander zugeordneten Magneteinheiten (115.3, 115.4; 315.3, 315.4) (115.3, 115.4; 315.3, 315.4) umfasst, die zur Erzeugung der Magnetstützkraft zumindest in Richtung der Magnetstützkraft berührungslos zusammenwirken,
wobei insbesondere
- eine erste Magneteinheit eines Magneteinheitenpaares (115.2) mechanisch mit der ersten Stützstruktur (111.1) verbunden ist und eine zweite Magneteinheit des Magneteinheitenpaares (115.2) mechanisch mit der zweiten Stützstruktur (111.2) verbunden ist
und/oder
- die Magneteinheiten (115.3, 115.4; 315.3, 315.4) wenigstens eines Magneteinheitenpaares (115.2) derart ausgebildet und angeordnet sind, dass ihr Beitrag zu der Magnetstützkraft über eine gegenseitige Abstoßung der beiden Magneteinheiten (115.3, 115.4; 315.3, 315.4) erfolgt,
und/oder
- die Magneteinheiten (115.3, 115.4) wenigstens eines Magneteinheitenpaares (115.2) derart ausgebildet und angeordnet sind, dass ihr Beitrag zu der Magnetstützkraft über eine gegenseitige Anziehung der beiden Magneteinheiten (115.3, 115.4) erfolgt.

5. Anordnung nach Anspruch 4, wobei
- wenigstens einer Stützeinheit (113.1) der Stützeinrichtung (113), insbesondere wenigstens einer Stützfedereinrichtung (113.1) der Stützeinrichtung (113), wenigstens ein Magneteinheitenpaar (115.2) funktionell, insbesondere räumlich, zugeordnet ist,
wobei insbesondere
- mehreren Stützeinheiten (113.1), insbesondere mehreren der Stützfedereinrichtungen (113.1), insbesondere jeder der Stützeinheiten (113.1), insbesondere jeder der Stützfedereinrichtungen (113.1), jeweils wenigstens ein Magneteinheitenpaar (115.2), insbesondere genau ein Magneteinheitenpaar (115.2), funktionell zugeordnet ist.

6. Anordnung nach einem der Ansprüche 1 bis 5, wobei
- wenigstens eine Magneteinheit (115.3, 115.4; 315.3, 315.4) der Magneteinrichtung (115.1) wenigstens einen Permanentmagneten umfasst,
wobei insbesondere
- die beiden Magneteinheiten (115.3, 115.4; 315.3, 315.4) eines Magneteinheitenpaares (115.2) der Magneteinrichtung (115.1), jeweils wenigstens einen Permanentmagneten umfassen
und/oder
- wenigstens eine erste Magneteinheit (315.3) eines Magneteinheitenpaares (115.2) der Magneteinrichtung (115.1) eine Mehrzahl von Permanentmagneten umfasst, deren Magnetfelder einander derart überlagert sind, dass in Richtung des Beitrags zur Magnetstützkraft, der durch das Magneteinheitenpaar (115.2) erzeugt wird, über einen vorgebbaren Bewegungsabschnitt eine Magnetkraft mit einem vorgebbaren Verlauf, insbesondere eine im Wesentlichen konstante Magnetkraft, auf eine zweite Magneteinheit (315.4) eines Magneteinheitenpaares (115.2) wirkt.

7. Anordnung nach einem der Ansprüche 1 bis 6, wobei
- die Magneteinrichtung (115.1) derart ausgebildet ist, dass die Magnetstützkraft mit zunehmender Relativlageänderung zumindest abschnittsweise proportional zunimmt,
und/oder
- die Magneteinrichtung (115.1) derart ausgebildet ist, dass die Magnetstützkraft mit zunehmender Relativlageänderung zumindest abschnittsweise überproportional zunimmt,
und/oder
- die Magneteinrichtung (115.1) derart ausgebildet ist, dass die Magnetstützkraft mit zunehmender Relativlageänderung zumindest abschnittsweise im Wesentlichen konstant ist.

8. Anordnung nach einem der Ansprüche 1 bis 7, wobei
- wenigstens eine Magneteinheit (115.3, 115.4; 315.3, 315.4) der Magneteinrichtung (115.1) im Betrieb in einer Stützkraftrichtung eine magnetisch erzeugte Stützkraft auf eine der Stützstrukturen ausübt,
- die wenigstens eine Magneteinheit (115.3, 115.4; 315.3, 315.4) über eine Entkopplungseinrichtung (115.8; 215.8; 315.8) mechanisch mit der Stützstruktur (111.2) verbunden ist, insbesondere mit der zweiten Stützstruktur (111.2) verbunden ist, und
- die Entkopplungseinrichtung (115.8; 215.8; 315.8) dazu ausgebildet ist, in wenigstens einem von der Stützkraftrichtung verschiedenen Entkopplungsfreiheitsgrad eine zumindest teilweise mechanische Entkopplung zwischen der Magneteinheit (115.3, 115.4; 315.3, 315.4) und der Stützstruktur (111.2) zu erzeugen,
wobei insbesondere
- der wenigstens eine Entkopplungsfreiheitsgrad ein translatorischer Freiheitsgrad ist, der quer zu der Stützkraftrichtung verläuft,
und/oder
- der wenigstens eine Entkopplungsfreiheitsgrad ein rotatorischer Freiheitsgrad um eine Achse ist, die quer zu der Stützkraftrichtung verläuft.

9. Anordnung nach einem der Ansprüche 1 bis 7, wobei
- wenigstens eine Magneteinheit (115.3, 115.4; 315.3, 315.4) der Magneteinrichtung (115.1) im Betrieb in einer Stützkraftrichtung eine magnetisch erzeugte Stützkraft auf eine der Stützstrukturen ausübt und
- die wenigstens eine Magneteinheit (115.3, 115.4; 315.3, 315.4) über eine Entkopplungseinrichtung (115.8; 215.8; 315.8), die sich in der Stützkraftrichtung erstreckt, mechanisch mit der Stützstruktur (111.2) verbunden ist,
wobei insbesondere
- die Entkopplungseinrichtung (115.8; 215.8; 315.8) ein in der Stützkraftrichtung langgestrecktes biegeweiches Entkopplungselement umfasst
und/oder
- die Entkopplungseinrichtung (115.8; 215.8; 315.8) ein in der Stützkraftrichtung langgestrecktes Blattfederelement umfasst
und/oder
- die Entkopplungseinrichtung (115.8; 215.8; 315.8) ein in der Stützkraftrichtung langgestrecktes und schlankes, insbesondere biegeweiches, Stabfederelement umfasst.

10. Anordnung nach einem der Ansprüche 1 bis 8, wobei
- eine Steuereinrichtung (109) vorgesehen ist und
- die Steuereinrichtung (109) dazu ausgebildet ist, in Abhängigkeit von einer Zustandsänderung der Stützeinrichtung (113.1), insbesondere in Abhängigkeit von einer Längenänderung wenigstens einer Stützfedereinrichtung (113.1) der Stützeinrichtung (113.1) entlang ihrer Stützkraftrichtung, die Magneteinrichtung (115.1) zur Änderung der Magnetstützkraft anzusteuern,
wobei insbesondere
- die Steuereinrichtung (109) zur Ermittlung der Zustandsänderung, insbesondere der Längenänderung der wenigstens einen Stützfedereinrichtung (113.1) entlang ihrer Stützkraftrichtung, ein das Lageänderungsverhalten der Stützeinrichtung (113) beschreibendes, insbesondere zeitabhängiges, Zustandsänderungsmodell verwendet, insbesondere ein das Kriechverhalten der Stützfedereinrichtung (113.1) beschreibendes, insbesondere zeitabhängiges, Kriechmodell der Stützfedereinrichtung (113.1) verwendet.

11. Anordnung nach einem der Ansprüche 1 bis 10, wobei
- eine Erfassungseinrichtung (109.4) und eine Steuereinrichtung (109) vorgesehen ist,
- die Erfassungseinrichtung (109.4) dazu ausgebildet ist, wenigstens einen für die Relativlage zwischen der ersten Stützstruktur (111.1) und der zweiten Stützstruktur (111.2) in wenigstens einem Korrekturfreiheitsgrad repräsentativen Relativlageerfassungswert zu erfassen und an die Steuereinrichtung (109) auszugeben, und
- die Steuereinrichtung (109) dazu ausgebildet ist, in Abhängigkeit von dem Relativlageerfassungswert, insbesondere in Abhängigkeit von einer zeitlichen Änderung des Relativlageerfassungswerts, die Magneteinrichtung (115.1) zur Änderung der Magnetstützkraft anzusteuern.

12. Anordnung nach Anspruch 11, wobei
- die Steuereinrichtung (109) dazu ausgebildet ist, die Magneteinrichtung (115.1) erst anzusteuern, wenn eine Abweichung des Relativlageerfassungswerts von einem vorgebbaren Relativlagesollwert in dem wenigstens einen Korrekturfreiheitsgrad einen vorgebbaren Grenzwert überschreitet,
wobei insbesondere
- der Korrekturfreiheitsgrad ein Rotationsfreiheitsgrad ist, insbesondere ein Rotationsfreiheitsgrad um eine quer zu der Gravitationsrichtung verlaufende Kippachse ist, und der vorgebbare Grenzwert für eine Abweichung der Relativlage zwischen der ersten Stützstruktur (111.1) und der zweiten Stützstruktur (111.2) von einer vorgebbaren Relativsolllage um 1 µrad bis 500 µrad, vorzugsweise 10 µrad bis 300 µrad, weiter vorzugsweise 20 µrad bis 100 µrad,, repräsentativ ist
und/oder
- der Korrekturfreiheitsgrad ein Translationsfreiheitsgrad ist, insbesondere ein Translationsfreiheitsgrad entlang der Gravitationsrichtung ist, und der vorgebbare Grenzwert für eine Abweichung der Relativlage zwischen der ersten Stützstruktur (111.1) und der zweiten Stützstruktur (111.2) von einer vorgebbaren Relativsolllage um 1 µm bis 500 µm, vorzugsweise 10 µm bis 300 µm, weiter vorzugsweise 20 µm bis 100 µm,, repräsentativ ist.

13. Optische Abbildungseinrichtung, insbesondere für die Mikrolithographie, mit
- einer Beleuchtungseinrichtung (102) mit einer ersten optischen Elementgruppe (106),
- einer Objekteinrichtung (104) zur Aufnahme eines Objekts (104.1),
- einer Projektionseinrichtung (103) mit einer zweiten optischen Elementgruppe (107) und
- einer Bildeinrichtung (105), wobei
- die Beleuchtungseinrichtung (102) zur Beleuchtung des Objekts (104.1) ausgebildet ist und
- die Projektionseinrichtung (103) zur Projektion einer Abbildung des Objekts (103.1) auf die Bildeinrichtung (105) ausgebildet ist,
**dadurch gekennzeichnet, dass**
- die Beleuchtungseinrichtung (102) und/oder die Projektionseinrichtung (103) wenigstens eine Anordnung (108) nach einem der Ansprüche 1 bis 12 umfasst.

14. Verfahren für eine optische Abbildungseinrichtung für die Mikrolithographie, insbesondere für die Verwendung von Licht im extremen UV-Bereich (EUV), bei dem
- eine erste Stützstruktur (111.1) eine zweite Stützstruktur (111.2) über eine Stützeinrichtung (113) abstützt und dazu ausgebildet ist, wenigstens ein optisches Element der Abbildungseinrichtung abzustützen,
- die zweite Stützstruktur (111.2) eine Messeinrichtung (109.1) abstützt, die zum Messen der Position und/oder Orientierung des wenigstens einen optischen Elements bezüglich einer Referenz (112), insbesondere einer Referenz (112) der zweiten Stützstruktur (111.2), in wenigstens einem Freiheitsgrad bis hin zu allen sechs Freiheitsgraden im Raum ausgebildet ist,
**dadurch gekennzeichnet, dass**
- eine Änderung einer statischen Relativlage zwischen der ersten Stützstruktur (111.1) und der zweiten Stützstruktur (111.2) in wenigstens einem Freiheitsgrad in einem Kompensationsschritt zumindest reduziert wird,
wobei
- kinematisch parallel zu der Stützeinrichtung (113) zwischen der ersten Stützstruktur (111.1) und der zweiten Stützstruktur (111.2) eine der Relativlageänderung entgegenwirkende magnetisch erzeugte Magnetstützkraft ausgeübt wird.

15. Verfahren nach Anspruch 14, wobei
- wenigstens ein Anteil der Gesamtgewichtskraft der zweiten Stützstruktur (111.2) und der von der zweiten Stützstruktur (111.2) getragenen Komponenten durch die Magnetstützkraft ausgeglichen wird,
wobei insbesondere
- der Anteil wenigstens 0,5% bis 20%, vorzugsweise wenigstens 1% bis 15%, weiter vorzugsweise wenigstens 2% bis 5%, der Gesamtgewichtskraft beträgt.

16. Verfahren nach Anspruch 14 oder 15, wobei
- die Magnetstützkraft durch ein Magneteinheitenpaar (115.2) aus zwei einander zugeordneten Magneteinheiten (115.3, 115.4; 315.3, 315.4) erzeugt wird, die zumindest in Richtung der Magnetstützkraft berührungslos zusammenwirken,
wobei insbesondere
- eine erste Magneteinheit (115.3, 115.4; 315.3, 315.4) eines Magneteinheitenpaares (115.2) mechanisch mit der ersten Stützstruktur (111.1) verbunden ist und eine zweite Magneteinheit (115.3, 115.4; 315.3, 315.4) des Magneteinheitenpaares (115.2) mechanisch mit der zweiten Stützstruktur (111.2) verbunden ist
und/oder
- der Beitrag die Magneteinheiten (115.3, 115.4; 315.3, 315.4) wenigstens eines Magneteinheitenpaares (115.2) zu der Magnetstützkraft über eine gegenseitige Abstoßung oder Anziehung der beiden Magneteinheiten (115.3, 115.4; 315.3, 315.4) erfolgt.
und/oder
- wenigstens eine erste Magneteinheit (115.3, 115.4; 315.3, 315.4) eines Magneteinheitenpaares (115.2) der Magneteinrichtung (115.1) eine Mehrzahl von Permanentmagneten umfasst, deren Magnetfelder einander derart überlagert sind, dass in Richtung des Beitrags zur Magnetstützkraft, der durch das Magneteinheitenpaar (115.2) erzeugt wird, über einen vorgebbaren Bewegungsabschnitt eine Magnetkraft mit einem vorgebbaren Verlauf, insbesondere eine im Wesentlichen konstante Magnetkraft, auf eine zweite Magneteinheit (115.3, 115.4; 315.3, 315.4) eines Magneteinheitenpaares (115.2) wirkt.

17. Verfahren nach Anspruch 16, wobei
- mittels wenigstens einer Magneteinheit (115.3, 115.4; 315.3, 315.4) im Betrieb in einer Stützkraftrichtung eine magnetisch erzeugte Stützkraft auf eine der Stützstrukturen ausgeübt wird,
- die wenigstens eine Magneteinheit (115.3, 115.4; 315.3, 315.4) mechanisch mit der Stützstruktur (111.2) verbunden ist, insbesondere mit der zweiten Stützstruktur (111.2) verbunden ist, und
- in wenigstens einem von der Stützkraftrichtung verschiedenen Entkopplungsfreiheitsgrad eine zumindest teilweise mechanische Entkopplung zwischen der Magneteinheit (115.3, 115.4; 315.3, 315.4) und der Stützstruktur (111.2) erfolgt,
wobei insbesondere
- der wenigstens eine Entkopplungsfreiheitsgrad ein translatorischer Freiheitsgrad ist, der quer zu der Stützkraftrichtung verläuft,
und/oder
- der wenigstens eine Entkopplungsfreiheitsgrad ein rotatorischer Freiheitsgrad um eine Achse ist, die quer zu der Stützkraftrichtung verläuft.

18. Verfahren nach einem der Ansprüche 14 bis 17, wobei
- die Magnetstützkraft mit zunehmender Relativlageänderung zumindest abschnittsweise proportional erhöht wird,
und/oder
- die Magnetstützkraft mit zunehmender Relativlageänderung zumindest abschnittsweise überproportional erhöht wird,
und/oder
- die Magnetstützkraft mit zunehmender Relativlageänderung zumindest abschnittsweise im Wesentlichen konstant gehalten wird.

19. Verfahren nach einem der Ansprüche 14 bis 18, wobei
- die Magnetstützkraft in Abhängigkeit von einer Zustandsänderung der Stützeinrichtung (113.1), insbesondere in Abhängigkeit von einer Längenänderung wenigstens einer Stützfedereinrichtung (113.1) der Stützeinrichtung (113.1) entlang ihrer Stützkraftrichtung, geändert wird,
wobei insbesondere
- zur Ermittlung der Zustandsänderung, insbesondere der Längenänderung der wenigstens einen Stützfedereinrichtung (113.1) entlang ihrer Stützkraftrichtung, ein das Lageänderungsverhalten der Stützeinrichtung (113) beschreibendes, insbesondere zeitabhängiges, Zustandsänderungsmodell verwendet, insbesondere ein das Kriechverhalten der Stützfedereinrichtung (113.1) beschreibendes, insbesondere zeitabhängiges, Kriechmodell der Stützfedereinrichtung (113.1) verwendet wird.

20. Verfahren nach einem der Ansprüche 14 bis 19, wobei
- wenigstens ein für die Relativlage zwischen der ersten Stützstruktur (111.1) und der zweiten Stützstruktur (111.2) in wenigstens einem Korrekturfreiheitsgrad repräsentativer Relativlageerfassungswert erfassen wird und
- in Abhängigkeit von dem Relativlageerfassungswert, insbesondere in Abhängigkeit von einer zeitlichen Änderung des Relativlageerfassungswerts, die Magnetstützkraft geändert wird.

21. Verfahren nach Anspruch 20, wobei
- die Magnetstützkraft erst geändert wird, wenn eine Abweichung des Relativlageerfassungswerts von einem vorgebbaren Relativlagesollwert in dem wenigstens einen Korrekturfreiheitsgrad einen vorgebbaren Grenzwert überschreitet,
wobei insbesondere
- der Korrekturfreiheitsgrad ein Rotationsfreiheitsgrad ist, insbesondere ein Rotationsfreiheitsgrad um eine quer zu der Gravitationsrichtung verlaufende Kippachse ist, und der vorgebbare Grenzwert für eine Abweichung der Relativlage zwischen der ersten Stützstruktur (111.1) und der zweiten Stützstruktur (111.2) von einer vorgebbaren Relativsolllage um 1 µrad bis 500 µrad, vorzugsweise 10 µrad bis 300 µrad, weiter vorzugsweise 20 µrad bis 100 µrad, repräsentativ ist
und/oder
- der Korrekturfreiheitsgrad ein Translationsfreiheitsgrad ist, insbesondere ein Translationsfreiheitsgrad entlang der Gravitationsrichtung ist, und der vorgebbare Grenzwert für eine Abweichung der Relativlage zwischen der ersten Stützstruktur (111.1) und der zweiten Stützstruktur (111.2) von einer vorgebbaren Relativsolllage um 1 µm bis 500 µm, vorzugsweise 10 µm bis 300 µm, weiter vorzugsweise 20 µm bis 100 µm, repräsentativ ist.
